# EUROPEAN PATENT SPECIFICATION

(11) **EP 3 129 810 B1**
(45) Date of publication and mention of the grant of the patent: **19.09.2018**
(21) Application number: 15713958.5
(22) Date of filing: 10.04.2015
(51) Int. Cl.: G02B 5/02, G02B 5/28, G02B 5/26, H02S 40/44, H01L 31/0525

(54) **SOLAR PHOTOVOLTAIC MODULE**
FOTOVOLTAISCHES SOLARMODUL
MODULE PHOTOVOLTAÏQUE SOLAIRE

(30) Priority: 10.04.2014 WO PCT/EP2014/057256
(43) Date of publication of application: 15.02.2017
(73) Proprietor: CSEM Centre Suisse d'Electronique et de Microtechnique SA, 2002 Neuchâtel (CH)
(72) Inventor: BALLIF, Christophe, CH-2000 Neuchâtel (CH); ESCARRE PALOU, Jordi, CH-2000 Neuchâtel (CH); PERRET-AEBI, Laure-Emmanuelle, CH-2000 Neuchâtel (CH); LI, Hengyu, 2068 Hauterive (CH)
(74) Representative: P&TS SA (AG, Ltd.)
(86) International application number: PCT/EP2015/057904
(87) International publication number: WO 2015/155356

(56) References cited:
- EP-A1- 1 837 920
- WO-A1-2004/079278
- WO-A1-2014/045144
- WO-A2-2014/045141
- US-A1- 2010 096 011
- US-B1- 6 208 466

## Description

### Technical Field

The invention relates to the field of solar photovoltaic modules. More particularly, the present invention relates to a solar photovoltaic module comprising an infrared transmitting cover sheet positioned in front of a photosensitive element of the solar photovoltaic modules.

### Background of the invention

Despite the wide diversity of available solar technologies, solar energy systems are still not considered as main stream technologies in building practice. So far most photovoltaic systems are optimized only for efficiency which implies absorbing a maximum number of photons, and hence leading to a dark blue and ideally black color appearance. Most of the photovoltaic cells on the market are crystalline cells with connecting ribbons which have an unaesthetic appearance.

One of the reasons of the lack of wide spread use of solar technologies for buildings is the lack of awareness and knowledge of integration possibilities among architects and the lack of solar products designed for building integration. In parallel there is a recent trend to transform buildings from energy users to energy producers. The old wide spread concept of adding solar panels on the roof of a building has evolved and a lot of effort is being done to merge the construction technology with the science and technology of photovoltaics in what is called the Building Integrated Photovoltaics (BIPV). Architectural, structural and aesthetic solutions are being constantly sought to integrate solar photovoltaic elements into buildings, allowing the incorporation of energy generation into everyday structures such as homes, schools, offices, hospitals and all kind of buildings. Photovoltaic modules can have a wide variety of functions such as noise protection, safety, electromagnetic shielding, thermal isolation etc. Photovoltaic elements can also be used to combine these functions with an aesthetic function. With such an approach solar photovoltaic modules become more and more construction elements serving as building exteriors such as façades and inclined roofs. If well applied, solar photovoltaic modules can increase a building's character and its value. It is of course important that the photoelectric conversion efficiency stays high.

The more technologies will be available to create aesthetic effects with photovoltaic cells the more the technology will be accepted and costs will decline. Not only new building construction will profit from this trend but also the improvement and modification of existing buildings. Architects who apply photovoltaic modules in an intelligent manner can as such contribute largely to the acceptance of this technology.

More particularly, a growing number of photovoltaic applications require photovoltaic cells that have, arranged to their incident light side, color films which satisfy at the same time four fundamental criteria:
- the color films should have a very high near-infrared transmission;
- a wide range of colored effects should be provided in reflection;
- the transmitted visible light intensity through the color films should be small enough so that when attached to a photovoltaic cell, this photovoltaic cell becomes invisible for an observer. The acceptable amount of transmitted visible light will depend on the color and color contrast of the different areas of the photovoltaic cell. The residual light transmitted through the color film is converted in electricity;
- it is also desired that the produced reflection color effect is highly insensitive to the incidence angle of the light incident on the film and/or the viewing angle of an observer positioned to the incident light side of the photovoltaic module.

One of the technology improvements would be to dispose of a solar photovoltaic module that has an appearance that is more aesthetic than the classical blue-black appearance. In other approaches front colored glass is integrated with the photovoltaic modules, such as explained in the following publication: "Efficiency of silicon thin-film photovoltaic modules with a front colored glass; S.Pelisset et al., Proceedings CISBAT 2011, pp.37-42". This approach does not achieve the four mentioned criteria. It is also expensive. In other approaches technology solutions have been initiated to render a specific color to a photovoltaic cell by the deposition of multilayer antireflection coatings on such photovoltaic elements, as for example described in the article: " Reduction of optical losses in colored solar cells with multilayer antireflection coatings; J.H.Selj et al., Solar Energy Materials &Solar Cells 95, pp.2576-2582, 2011". These approaches do not allow to achieve the four mentioned optical criteria and have specifically a high angular dependence of the color effect which is unacceptable for the intended photovoltaic applications.

In another approach disclosed in EP 1837920 A1, an infrared-transmitting cover transmits near-infrared light and reflects a part of the visible light so that the film appears with a certain color. The visible light is partly reflected by a dielectric multilayer. In order to avoid that visible light is transmitted through the film a black absorbing layer, such as black paint, is arranged to the side opposite to the incident light side of the dielectric multilayer. The limitation of such approach is that the color appearance effect depends on the incident angle of the incident light beam. Moreover, the disclosed device completely blocks all visible light making it less suitable for photovoltaic applications as it absorbs all the residual transmitted visible light. Although this residual visible light may be a small percentage of the incident light on the film, it is important for photovoltaic cells to convert this residual light in electricity.

It is the objective of the present invention to bring a new approach in this field.

### Summary

The present invention provides a new solar photovoltaic module comprising an infrared transmitting cover sheet positioned in front of a near-infrared photo-electric conversion element of a solar photovoltaic module, such infrared transmitting cover sheet allowing to provide a colored aspect of solar photovoltaic modules. The invention has been made while seeking innovative solutions to integrate photovoltaic elements into buildings and give these photovoltaic elements an esthetic aspect, allowing to make photovoltaic elements more attractive for their integration in new or existing constructions such as for example roofs or facades.

To that problem a solution has been found with the solar photovoltaic module of the invention, which comprises an infrared transmitting cover sheet which passes as less as possible the visible light portion of incident light to a photovoltaic element or photoconversion device. Incident light is defined as an incident light beam having at least a visible portion of light and at least a near infrared portion of light, visible light being defined as light having a wavelength between 380nm and 700nm, excluding 700nm and near infrared light is defined as light having a wavelength between 700nm and 2000nm. The infrared transmitting cover sheet, also defined as color filter, color foil or color sheet, provides further a homogeneous colored aspect to a photovoltaic module. Arranging said infrared transmitting cover sheet in front of infrared photosensitive devices or elements allows to hide from an observer the connecting elements, borders or other non-esthetic features and/or colors of the photosensitive parts of said infrared photosensitive devices or elements.

The perceived color of the photovoltaic cell comprising said infrared transmitting cover sheet is also substantially independent of the incidence angle of the incident light and/or the viewing angle of the observer.

At the same time it has to be assured that the photoconversion element or device has to keep an acceptable photoconversion efficiency, preferably higher than 10%. Therefore high near-infrared transmittance of the infrared transmitting cover sheet of the solar photovoltaic module has to be guaranteed.

The infrared transmitting cover sheet should also pass residual visible light that is not used to create the color reflection effect. Recuperating this residual light is important in the case wherein the color sheet is arranged to a photoelectric device, because any small improvement, even only some percentage of the incident light, increases the photoelectric conversion efficiency of the cell.

The invented photovoltaic module comprising said infrared transmitting cover sheet allows to provide a solution to the problem of providing solar photovoltaic modules with improved aesthetics and acceptable conversion efficiencies to be used in BIPV applications. It allows to provide to the photovoltaic module a homogeneous colored appearance, including white, it allows to convert near infrared light and residual visible light passing through the infrared transmitting cover sheet of the photovoltaic module into electricity, and the colored appearance of the photovoltaic module is substantially independent of the angle of the incident light and/or the viewing angle.

More specifically the invention relates to a solar photovoltaic module comprising the features defined in claim 1.

The infrared transmitting cover sheet arranged to said photovoltaic element of the solar photovoltaic module may be realized according to different types: a first type, a second type and a third type of infrared transmitting cover sheets. Providing three complementary types of said infrared transmitting cover sheet, of which at least one is arranged in said solar photovoltaic module allows to be able to cover a wide range of color appearance possibilities of the solar photovoltaic module to an observer.

These color appearances are substantially independent of the incidence angle of the incident light and/or the viewing angle of the observer.

Each of said first type, second type and third type of infrared transmitting cover sheets comprise said interference multilayer and this interference multilayer is called the first interference multilayer, the second interference multilayer and the third interference multilayer in respectively first type, a second type and a third type of infrared transmitting cover sheets. Said first interference multilayer, said second interference multilayer and said third interference multilayer may be different types of interference multilayers but have always the above mentioned optical transmission characteristics of said interference multi layer.

The solar photovoltaic module may comprise a bifacial photovoltaic element or may comprise two photovoltaic elements. At each side of a solar photovoltaic module comprising a bifacial photovoltaic element, or two photovoltaic elements arranged back-to-back, an infrared transmitting cover sheet may be arranged. A different type of infrared transmitting cover sheet may be arranged to each side of such a solar photovoltaic module.

A first type of infrared transmitting cover sheet comprises at least
- a front sheet arranged to the incident light side of said infrared transmitting cover sheet,
- a scattering layer arranged on said front sheet, to the side opposite to the incident light side
- a first multilayer arranged on said scattering layer, said first multilayer comprising at least a first interference multilayer, said first interference multilayer comprising at least one absorption layer.
Said front sheet, said scattering layer and said first multilayer cooperate with one another so as to form said infrared transmission means, said visible light transmission means and said reflection means.
Said first type of infrared transmitting cover sheet is an appropriate solution for infrared transmitting cover sheets having preferred color appearances of the infrared transmitting cover sheet to an observer, such as grey, brown, terracotta, gold-like and red colors. To the contrary of the second and third type of infrared transmitting cover sheet, said first type of infrared transmitting cover sheet is less suited for blue, green and high luminance colors.

A second type of infrared transmitting cover layer comprises at least
- a substrate;
- a second multilayer arranged on said substrate, said second multilayer comprising at least a second interference multilayer, said second interference multilayer comprising at least an absorption layer,
   said substrate and said second multilayer cooperate with one another so as to form said infrared transmission means, said visible light transmission means and said reflection means.
Said second type of infrared transmitting cover sheet is an appropriate solution for infrared transmitting cover sheets having preferred color appearances of the infrared transmitting cover sheet such as metallic-like colors, and is less suited for infrared transmitting cover sheets having blue and green color appearances.

A third type of infrared transmitting cover sheet comprises at least:
- an absorption front sheet, arranged to the incident light side of said infrared transmitting cover sheet and comprising substances that absorb at least a portion of said incident visible light,
- a third multilayer arranged on said absorption front sheet, to the side opposite to the incident light side, said third multilayer comprising at least a third interference multilayer,

Said absorption front sheet and said third multilayer cooperate with one another so as to form said infrared transmission means, said visible light transmission means and said reflection means.

Said third type of infrared transmitting cover sheet is an appropriate solution for a very wide range of possible color appearances of the infrared transmitting cover sheet and there is no preferred color range for said third type of infrared transmitting cover sheet.

The solar photovoltaic module may comprise different types of layers that allow to have a wide design flexibility of the color appearance of the solar photovoltaic module. In an embodiment a light diffusion layer comprising microbeads may be arranged. In another embodiment a scattering layer may be arranged. In a variant, said light diffusion layer may be combined with a scattering layer.

Also, depending on the type of infrared transmitting cover sheet that is chosen, specific encapsulant layers may be used, such as an encapsulant layer doped with colored substances.

In an embodiment the solar photovoltaic module may comprise at least a protection layer, which is preferably a glass layer. Said infrared transmitting cover sheet may be arranged to said protection layer. Said infrared transmitting cover sheet may be arranged to either side of said protection layer. In the case of a solar photovoltaic module comprising bifacial photovoltaic element or two photovoltaic elements, different protection layers and different types of infrared transmitting cover sheets may be arranged to each side of the solar photovoltaic module.

The solar photovoltaic module may comprise at least an antireflection layer arranged to either said protection layer or said first, second or third infrared transmitting cover layer.

### Brief description of the figures

Fig. 1 shows a first type infrared transmitting cover sheet;
Fig. 2 illustrates the light trapping of a portion of visible light in a high-index layer of an infrared transmitting cover sheet;
Fig. 3 shows another first type infrared transmitting cover sheet;
Fig. 4 shows a second type infrared transmitting cover sheet;
Fig. 5 shows another second type infrared transmitting cover sheet;
Fig. 6a shows a third type infrared transmitting cover sheet;
Fig. 6b shows another third type infrared transmitting cover sheet;
Fig.7a-d show different variants of a light dispersion layer;
Fig. 8a-c show different embodiments of a third type infrared transmitting cover sheet;
Fig. 9 shows a standard solar photovoltaic module of prior art;
Fig. 10a shows a solar photovoltaic module comprising an infrared transmitting cover sheet;
Fig. 10b shows a solar photovoltaic module comprising an infrared transmitting cover sheet and a protection layer arranged to the side of the incident light;
Fig. 10c shows a solar photovoltaic module comprising a protection layer and an infrared transmitting cover sheet arranged to the protection layer, to the side of the incident light;
Fig. 11a shows a solar photovoltaic module comprising a bifacial photovoltaic element and an infrared transmitting cover sheet arranged to a first side of the bifacial photovoltaic element;
Fig. 11b shows a solar photovoltaic module comprising a bifacial photovoltaic element, an infrared transmitting cover sheet arranged to a first side of the bifacial photovoltaic element, and a protection layer arranged to the infrared transmitting cover sheet;
Fig. 11c shows a solar photovoltaic module comprising a bifacial photovoltaic element, a protection layer arranged to a first side of the bifacial photovoltaic element, and an infrared transmitting cover sheet arranged to the protection layer;
Fig. 12a shows a solar photovoltaic module comprising a bifacial photovoltaic element and an infrared transmitting cover sheet arranged to each side of the bifacial photovoltaic element;
Fig. 12b shows a solar photovoltaic module comprising a bifacial photovoltaic element comprising an infrared transmitting cover sheet arranged to each side of the bifacial photovoltaic element, a protection layer arranged to a first infrared transmitting cover sheet and a back sheet layer arranged to a second infrared transmitting cover sheet;
Fig. 12c shows a solar photovoltaic module comprising a bifacial photovoltaic element comprising a protection layer arranged to one side of the bifacial photovoltaic element, a back sheet layer arranged to a second side of the bifacial photovoltaic element, and comprising an infrared transmitting cover sheet arranged to the first and the second side of the solar photovoltaic module;
Fig. 13 shows a color chart with CIE color coordinates of first type infrared transmitting cover sheets;
Fig. 14a shows reflection characteristics of first type infrared transmitting cover sheets comprising a ZnO scattering layer;
Fig. 14b shows transmission characteristics of first type infrared transmitting cover sheets comprising a ZnO scattering layer;
Fig. 15a shows reflection characteristics of a first type infrared transmitting cover sheets comprising an acrylic scattering layer;
Fig. 15b shows transmission characteristics of a first type infrared transmitting cover sheets comprising an acrylic scattering layer;
Fig. 16 shows a table with CIE color coordinates of first type infrared transmitting cover sheets comprising a ZnO scattering layer;
Fig. 17 shows another table with CIE color coordinates of first type infrared transmitting cover sheets comprising an acrylic scattering layer;
Fig. 18a shows the current density-voltage curve measured under one-sun illumination of a solar photovoltaic module with and without first type infrared transmitting cover sheet;
Fig. 18b shows a table with open circuit voltage (V_{oc}), fill factor (FF), short circuit current density (J_{sc}) and conversion efficiency (Eff.) values measured for a solar photovoltaic module with and without first type infrared transmitting cover sheet;
Fig. 19 shows a color chart with CIE color coordinates of second type infrared transmitting cover sheet and of a reference layer of gold;
Fig. 20 shows reflection and transmission characteristics of second type infrared transmitting cover sheet and of a reference layer of gold;
Fig. 21 shows a table with CIE color coordinates of a second type infrared transmitting cover sheet and of a reference layer of gold;
Fig. 22a shows the external quantum efficiency curve of a solar photovoltaic module with and without second type infrared transmitting cover sheet;
Fig. 22b shows a table with short-circuit current density values measured for a solar photovoltaic module with and without second type infrared transmitting cover sheet;
Fig. 23 shows a color chart with CIE color coordinates of absorption sheets and third type infrared transmitting cover sheets;
Fig. 24 shows transmission characteristics of absorption sheets used in third type infrared transmitting cover sheets;
Fig. 25a shows reflection characteristics of third type infrared transmitting cover sheets;
Fig. 25b shows transmission characteristics of third type infrared transmitting cover sheets;
Fig. 26 shows a table with the CIE color coordinates of absorption sheets of a third type infrared transmitting cover sheet;
Fig. 27 shows another table with exemplary CIE color coordinates of third type infrared transmitting cover sheets;
Fig. 28a shows a current density-voltage curve measured under one-sun illumination of a solar photovoltaic module with and without a third type infrared transmitting cover sheet;
Fig. 28b shows a table with open circuit voltage (V_{oc}), fill factor (FF), short circuit current density (J_{sc}) and conversion efficiency (Eff.) values measured for a solar photovoltaic module with and without a third type infrared transmitting cover sheet.
Fig. 29 shows a table with the CIE color coordinates of preferred colors of first, second and third type infrared transmitting cover sheets.
Fig. 30 shows the visible light transmission of an infrared transmitting cover sheet and the external quantum efficiency (EQE) of a solar photovoltaic module with the same infrared transmitting cover sheet attached on top by means of an encapsulant layer;
Fig. 31 compares, in a color chart with CIE color coordinates, the color variance of an infrared transmitting cover of prior art with an infrared transmitting cover used to produce solar photovoltaic modules of the present invention.

### Detailed description

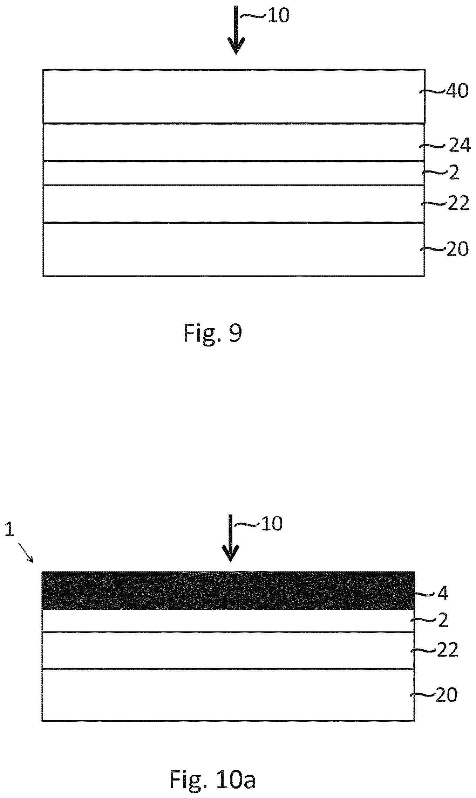

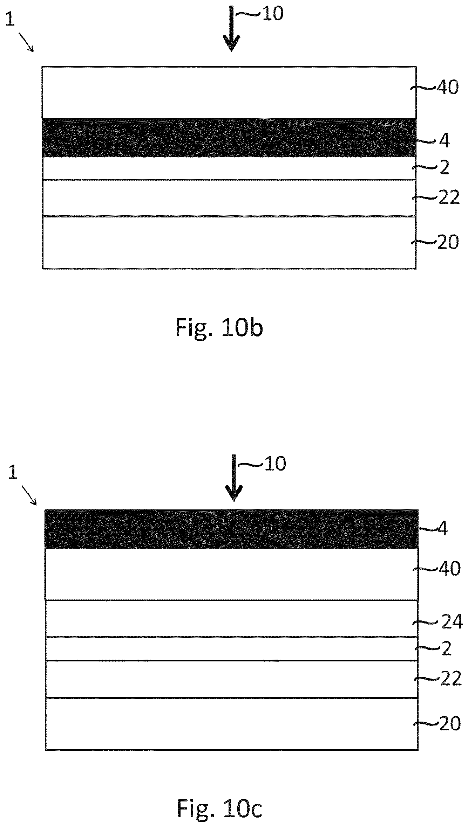

Figures 10-12 relate to a solar photovoltaic module 1, intended to receive incident light, comprising:
- a photovoltaic element 2, sensitive to near-infra red light,
- at least a first infrared transmitting cover sheet 4, arranged to one side of said photovoltaic element, comprising:
   - infrared transmission means arranged to transmit at least 65% of incident infrared light, defined between 700nm and 2000nm, through said infrared transmitting cover sheet, said 65% being defined as the mean transmission value integrated over the range of wavelengths between 700nm and 2000nm. Said transmission is defined as the ratio, expressed in %, of the transmitted and incident near-infrared-light.
   - visible light transmission means arranged to have an as less as possible transmission of incident light having wavelengths lower than 600m, preferably lower than 650nm, more preferably lower than 700nm, excluding the wavelength of 700nm, through said infrared transmitting cover sheet, said as less as possible transmission being preferably lower than 20%, preferably lower than 15%, and more preferably lower than 10%. Said transmission being defined as the average of the transmission values measured at each wavelength lower than 700nm. Said transmission is defined as the ratio, expressed in %, between the transmitted and the incident visible light. The as low as possible transmission values allow to hide to an observer any underlying structure of the solar photovoltaic module to an observer positioned to an incident light side.
   - reflection means arranged to reflect a portion of said incident visible light off said infrared transmitting cover sheet 4, to the side of said incident light. Said portion, also defined as reflected visible light or returned visible light beam or reflected visible light beam, is defined as a visible part of the incident light, provided by a light source, that is returned to the side of the light source that provides said incident light, said portion being preferably higher than 10%, preferably higher than 20% and more preferably higher than 40%. As an example, 40% of the incident visible light between 500nm and 600nm may be reflected by said reflection means. As another example, 15% of the incident visible light between 450nm and 550nm may be reflected by said reflection means. Hereafter the incident light surface is defined as a surface of said photovoltaic cell on which incident light, provided by a light source is incident. Said incident light may be light directly provided and transmitted by a light source to the solar photovoltaic module 1, but it may also be light provided by the at least partial reflection of the light, provided by a light source, of a reflecting or scattering surface, such as a wall, a floor, or a surface covered for example by snow, without limitation of the type of said reflecting or scattering surface.

Said infrared transmission means and said visible light transmission means and said reflection means comprise an interference multilayer, said interference multilayer having an averaged transmission of less than 10%, for normal incident visible light on said interference, said normal incidence being defined as being parallel to a normal to the infrared transmitting cover sheet 4.

The transmitted visible light intensity through the infrared transmitting cover sheet 4 should be small enough so that when arranged to the photovoltaic element 2, this photovoltaic element 2 or some parts of the photovoltaic element 2 becomes invisible for an observer. The acceptable amount of transmitted visible light will depend on the color and color contrast of the different areas of the photovoltaic element 2 and the back sheet layer 20.

For example, an infrared transmitting cover sheet 4, arranged to a solar panel comprising photovoltaic elements 2 , transmitting 30% of visible light makes individual photovoltaic elements 2 visible to an observer when a white color back sheet layer 20 is used. However, a black color back sheet layer 20 results in a homogeneous appearance of the solar panel 1 making individual photovoltaic elements 2 undistinguishable. Photovoltaic elements, also defined as PV cells, comprising high contrasted clear-dark contrast areas, require that less visible light must be transmitted through the infrared transmitting cover sheet 4 to make the PV cell 2, arranged behind the infrared transmitting cover sheet 4, invisible.

When the infrared transparent cover sheet 4 is applied to a solar panel, the visible light transmitted through that infrared transparent cover sheet 4 is to be converted in electricity.

The light source providing the incident light to the solar photovoltaic cell is preferably a broad band light source covering at least a range of the electromagnetic spectrum having wavelengths between 380nm and 2000nm, but may be a light source emitting light in at least a portion of the visible spectrum and in at least a portion of the near-infrared part of the spectrum.

The invention relates more specifically to a solar photovoltaic module 1 that may comprise a first type infrared transmitting cover sheet, or a second type infrared transmitting cover sheet, or a third type of infrared transmitting cover sheet types, or two of said infrared transmitting cover sheet types, said first, second and third infrared transmitting cover sheet types being arranged to provide a technical solution for said infrared transmission means, said visible light transmission means and said reflection means. Said infrared transmitting cover sheets are also defined hereafter as color films.

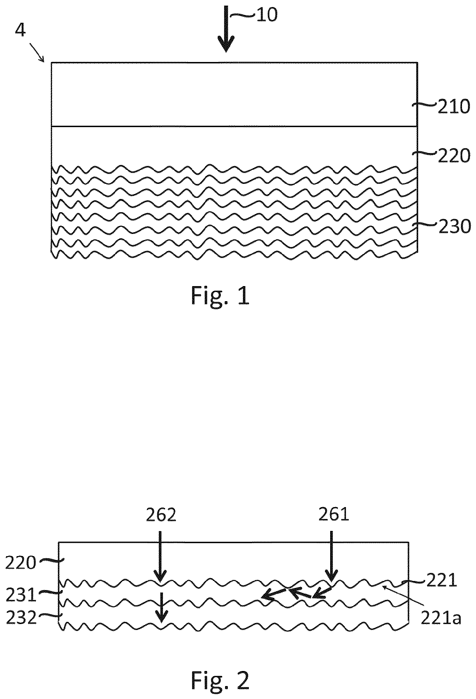

Fig. 1 illustrates an embodiment of the invention corresponding to said first type 1 of an infrared transmitting cover sheet. A front sheet 210 is arranged to the incident light side of said infrared transmitting cover sheet 4. Said front sheet 210 is based on a material selected from the group comprising glass, Polyethylene terephthalate (PET), Polycarbonate (PC), Polyethylene napthalate (PEN), Polymethyl methacrylate (PMMA), polyesters, polyethylene (PE), polypropylene (PP), Polyethylene furanoate, polymers based on poly (bis-cyclopentadiene) condensates, fluorine based polymers, colorless polyimide (CP), cellulose, PEEK polymers, and a combination thereof. The option to choose one of these materials or a combination allows to provide a wide range of solutions in terms of mechanical strength, rigidity, resistance to impacts, impermeability to water and resistance to temperature and UV radiation for said front sheet.

A scattering layer 220 is arranged on said front sheet 210. Said scattering layer 220 comprises, to the side opposite to the incident light 10, a structured surface 221a comprising surface nanofeatures 221 arranged to scatter at least a portion of said incident visible light 10. Said surface nanofeatures 221 may have a randomly or a periodically distribution, said distribution being defined substantially in the plane of said scattering layer 220. In a variant wherein said surface nanofeatures 221 have a random distribution, the heights of the peaks of said nanostructured surface features have a root-mean-square deviation (sRMS) smaller than 200 nm, preferably comprised between 10 nm and 75 nm. The lateral dimensions of said surface nanofeatures are defined by their correlation length (L) which is calculated as the radius where the autocorrelation peak drops to 1/e of its maximum value, assuming a circular shape. Said correlation length (L) is smaller than 1 micron, but is preferably comprised between 100 nm and 500 nm.

In a variant, said surface nanofeatures 221 have a periodic distribution, said distribution being defined substantially in the plane of said scattering layer 220, the peak to valley height of each period is smaller than 1 micron, and is preferably comprised between 100 nm and 300 nm. The period of the distribution of said surface nanofeatures 221 is smaller than 2 micron, and preferably comprised between 200 nm and 500 nm.

The refractive index of said scattering layer 220 layer is generally comprised between 1.48 and 2.3. The material of said scattering layer 220 may be a thermal or a UV curing resin, which may have been realized either by embossing or by molding. Said scattering layer 220 may also be a coated material grown in such a way as to provide a texture having nanostructures that have a predetermined shape, such as a pyramidal shape. The material of said scattering layer 220 may be chosen from the group comprising ZnO, SNO2:F, thermal or UV curable acrylic or epoxy based resins, or a combination thereof. A ZnO layer may be realized by deposition techniques such as Low Pressure Chemical Vapor Deposition (LPCVD). Said ZnO layer has a refractive index substantially close to 2 and may, under certain conditions, be grown so that pyramidal ZnO surface nanofeatures 221 are formed on said scattering layer 220. Under certain conditions, as the ones described in "Rough ZnO layers by LPCVD process and their effect in improving performances of amorphous and microcrystalline silicon solar cells; S. Fay et al. Solar Energy Materials & Solar Cells 90, pp. 2960 (2006)", the deposition of ZnO by LPCVD produce layers that have a columnar structure consisting of conical microcrystals. Said microcrystals emerge out to the surface of said ZnO layer forming superficial nanofeatures with a pyramidal shape. The size of said superficial nanofeatures increases with the thickness of the scattering layer 220. Thicknesses between 400 nm and 2 µm lead to the preferred nanofeatures 221 when using a scattering layer 220 made of ZnO.

Alternatively, said scattering layer 220 can be made of SnO2:F deposited by atmospheric pressure chemical vapor deposition (APCVD). Pyramidal nanofeatures 221 can be obtained on the surface of said scattering layer 220 by adapting the deposition parameters such as temperature, deposition time, tin precursor, additives or growth rate. Said scattering layer 220 may be a combination of at least one ZnO layer and at least one SnO2:F layer. Another technique to obtain a structured surface 221a for said scattering layer 220 is to roughen, by chemical etching, plasma treatment or mechanical techniques, the surface of said front sheet 210 to the side opposite to the incident light. An exemplary texturing technique comprises the step of chemically etching the surface of a glass front sheet by a solution of hydrofluoric acid. In a variant, a flat ZnO layer is deposited on a glass front sheet by sputtering and the texturing technique comprises the step of chemically etching the ZnO layer by a solution of hydrochloric acid. In another variant, the texturing technique comprises the step of etching the surface of a polymeric front sheet 210 based on polyester by using oxygen-argon plasma. The texture of said scattering layer 220 may also be obtained by embossing a polymeric foil or sheet or by imprinting a thermal or a UV curable acrylic resin.

A first multilayer 230 illustrated in Fig.1, is arranged on said scattering layer 220, to the side of said scattering layer 220 opposite to the incident light. Said first multilayer 230 comprises a first interference multilayer, defined as first interferential filter, and is designed and arranged to provide a partial reflection of a portion of the incident visible light and a substantially total transmission of said near-infrared part of the spectrum.

Said first interferential filter is made of a stack of layers, each layer of said stack having a different refractive index than the adjacent layer of said stack of layers. The materials of said stack of layers are chosen from the group comprising TiO2, Nb2O5, Ta2O5, ZrO2, Al2O3, SiO2, Si3N4, MgF2 and said stack of layers comprises at least one layer chosen from the group comprising amorphous silicon (a-Si:H), microcrystalline silicon (µc-Si:H), silicon oxide alloys (SiOx), germanium (Ge), silicon-germanium alloys (SiGe). At least one of the layers of said multilayer 230 comprises an absorbing layer arranged to absorb a fraction of said visible incident light.

The large range of possible materials that may be used to form said first interference multilayer allows to provide a large range of design capabilities to provide a wide range of possibilities to create a specific color appearance of said second type of infrared transmitting cover sheet 4 for an observer positioned at its incident light side.

In an advantageously chosen arrangement, the first layer 231 of said first interferential filter is a high-index layer of said first interferential filter, said high-index layer being defined as the layer of said first interferential filter that has the highest refractive index of the different layers that constitute said first interferential filter. By arranging said high-index layer 231 on said textured surface 221a of said scattering layer 220, and by arranging the size and distribution of said surface features 221, a portion 261 of the visible light spectrum is scattered into said high-index layer 231 and said portion 261 is guided, by multiple reflections and scattering, into said high-index layer 231.

Fig. 2 illustrates the light trapping of a portion 261 of the visible light in said high-index layer. A high refractive index layer 231 surrounded by low index media, 232 and 220, behaves as an optical waveguide. If the texture at the interface 221a of said media is adapted to scatter a portion of incident visible light, said portion 261 will be trapped by total internal reflection inside the high index medium 231 and its absorption will be increased as the light path of said portion 261 in said high index layer 231 is considerably increased. The absorption of the fraction 262 of visible light 10 that is not scattered in the interfaces is low and said fraction 262, defined as the transmitted visible light beam, is transmitted to the layers of said first interferential filter arranged to the side opposite to the incident light side. The amount of scattering at said interface 221a depends on the effective wavelength of the light incident at said interface 221a, and is related to the refractive index of the corrugated layer 220 by the following expression: λeff = λ/nlayer, λ defining the wavelength of the light in air. Thus, light absorption in said multilayer 230 and so in said infrared transmitting cover layer can be adapted to a predetermined amount by modifying the dimension of the scattering features 221 and/or the refractive index of the scattering layer 220.

By advantageously designing and arranging said scattering layer 220 of said first type infrared transmitting cover sheet, a preselected portion of said incident visible light 10 may be scattered and incoupled and guided into the first layer of the first interference multilayer and provide for said predetermined portion a long effective path length and so obtain a high absorption in said first layer, which is preferable a high refractive index layer. By choosing selectively the absorbed portion of visible light one may have an additional design parameter to provide a specific color appearance of said first type of infrared transmitting cover sheet for an observer positioned at its incident light side.

For example, by designing and arranging the surface features 221 of said scattering layer 220 so that the correlation length (L) of said surface features 221 is substantially close to 120 nm and by advantageously choosing the thickness of said high-index layer 231 as well as the appropriate material, said high-index layer 231 may be designed and arranged to absorb selectively at least a portion of the blue and green light part of the spectrum, defined as the range of wavelengths between 380 nm and 580 nm. By absorbing a portion of the blue and green part of the visible spectrum, the reflected visible part of the spectrum, by said interferential filter, will comprise the whole visible spectrum, excluding said absorbed portion of blue and green light, so that the appearance of said interferential filter, seen by an observer positioned to the incident light side of said infrared transmitting cover sheet, is red, or brown, or a terracotta-like color because substantially only the red part of the incident visible light is reflected by said interferential filter, to the side of the incident light.

In a variant, any layer of said first multilayer 230 may be arranged to enhance the light trapping, and as such enhance the absorption of a portion of said incident visible light, in that layer. In a variant, more than one layer of said multilayer may be arranged to enhance light trapping and so enhance said absorption. In another variant, at least one diffraction grating structure may be arranged in said multilayer.

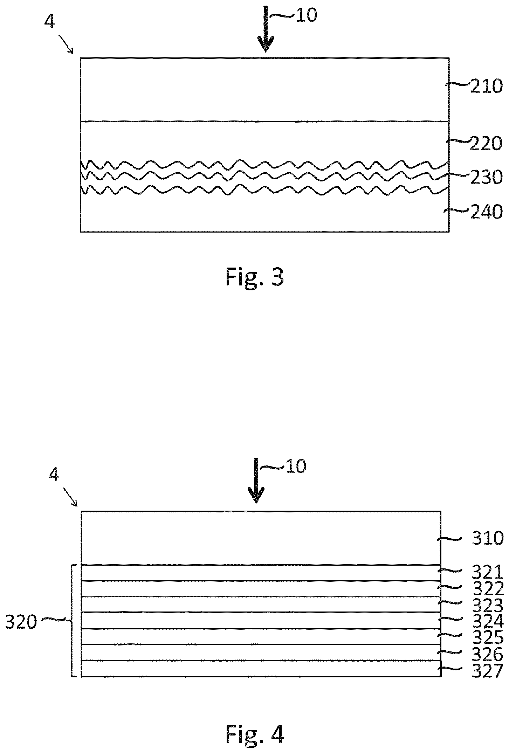

In a variant, shown in Fig.3, a first encapsulant layer 240 may be arranged on said first multilayer 230, to the side opposite to the incident light side. Examples of encapsulant materials are based on a material chosen among ethylene vinyl acetate (EVA), polyvinyl butyral (PVB), polyvinyl acetate (PVA), polyurethane (TPU), thermal Polyolefin (TPO), silicone elastomers, epoxy resins, and combinations thereof.

Arranging an encapsulant layer 240 to said first multilayer 230, to the opposite side of the incident light, allows to provide a solution to improve the adherence of said first type of infrared transmitting cover sheet to a surface such as an infrared photoconversion element or the like. If the infrared transmitting cover sheet is applied on an infrared photoconversion element, the encapsulant layer 240 together with the front sheet has the function to protect the infrared photoconversion element, from the combined action of changing temperature and humidity conditions of the environment, and ensures a long term high reliability of the infrared photoconversion element. The use of the mentioned materials of said encapsulating layer provides a wide range of solutions for said encapsulant layer.

In an embodiment an additional diffusing layer may be arranged on said front sheet 210 to give a mate appearance and/or to reduce the total reflection of said infrared transmitting cover layer 4. Said diffusing layer may be arranged on an additional foil arranged to said first infrared transmitting cover layer 4. In an embodiment said front sheet 210 may comprise at least a textured or roughened surface. In a variant, at least an anti-reflective coating may be arranged on said front sheet 210.

Fig. 4 illustrates an embodiment of the invention corresponding to a second type of an infrared transmitting cover sheet.

In the embodiment of Fig. 4 a second multilayer 320 is arranged to a front sheet 310. Said second multilayer 320 comprises at least a second interferential layer, said second interferential layer being similar to the first interferential layer of the embodiment of Figures 1, 2, 3, explained in par. [00041] to [00043], with the difference that said second interferential filter is not textured but has a substantial flat shape, comprising a stack of layers substantially parallel to the surface of said substrate facing said incident light 10. Also, said second interferential filter comprises at least a layer arranged to absorb a portion of the visible incident light 10. The materials of said absorbing layer are based on a material chosen from a-Si, µc-Si:H, SiOx, Ge, SiGe alloys, or their combination. Other visible light absorbing materials may be chosen in as far that they are substantially transparent to near-infrared light. In a variant all of the layers may be based on visible light absorbing materials and each of the layers may have different absorptions for different portions of the visible light.

Arranging at least one absorbing layer, in said second interference multilayer, which absorbs a portion of the incident visible light on said second type of infrared transmitting cover sheet 4 allows to provide specific metallic-like color appearances of said second type of infrared transmitting cover sheet for an observer positioned at its incident light side. Materials such as a-Si, SiOx, Ge, SiGe, may be used in said at least one absorbing layer as they have a higher absorption in the blue part of the spectrum than in the red part of the spectrum. The use of polymeric materials in said at least one absorbing layer comprising pigments and dyes allows having materials with better absorption of the green or red proportions of the visible spectrum than the blue portion of the spectrum, which allows to enlarge the range of colored appearances of the infrared transmitting cover sheet that may be obtained.

Said second interference multilayer of said second infrared transmitting cover sheet may comprise a plurality of polymeric layers arranged so that adjacent polymer layers have different refractive indexes. Said second interference multilayer may be made of a polymer, more specifically of a material selected from the group comprising polystyrene (PS), polycarbonate (PC), polyethylene (PE), polymethylmethacrylate (PMMA), and comprises at least one polymeric layer made partially absorptive to visible light by adding pigments or dyes to said polymeric layer.

Using polymers for said second interference multilayer allows to provide alternative design possibilities of the infrared transmitting cover sheet, especially in cases wherein an improved flexibility of said infrared transmitting cover sheet is desired.

Said front sheet 310 may be made of a material selected from the group comprising glass, Polyethylene terephthalate (PET), Polycarbonate (PC), Polyethylene napthalate (PEN), Polymethyl methacrylate (PMMA), polyesters, polyethylene (PE), polypropylene (PP), Polyethylene furanoate, polymers based on poly (bis-cyclopentadiene) condensates, fluorine based polymers, colorless polyimide (CP), cellulose, PEEK polymers, and a combination thereof. The option to choose one of these materials or a combination allows to provide a wide range of solutions in terms of mechanical strength, rigidity, resistance to impacts, impermeability to water and resistance to temperature and UV radiation for said front sheet.

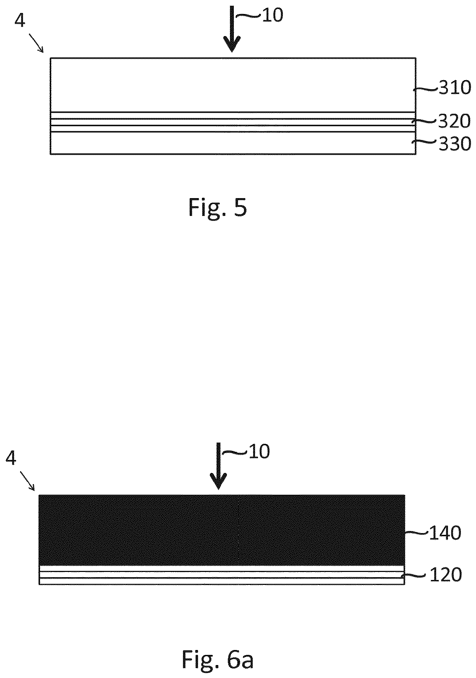

In an embodiment, shown in Fig. 5, a second encapsulating layer 330 may be arranged to said second interferential layer, to the side away from said front sheet 310. Arranging a second encapsulant layer 330 to said second multilayer allows to provide a solution to improve the adherence of said second type of infrared transmitting cover sheet 4 to an underlaying element such as a glass sheet or an infrared photosensitive element module or the like. The encapsulant layer combined with said front sheet 310 has the function to protect the underlaying, and invisible, device from the combined action of changing temperature and humidity conditions of the environment and allows to ensure a high long term reliability.

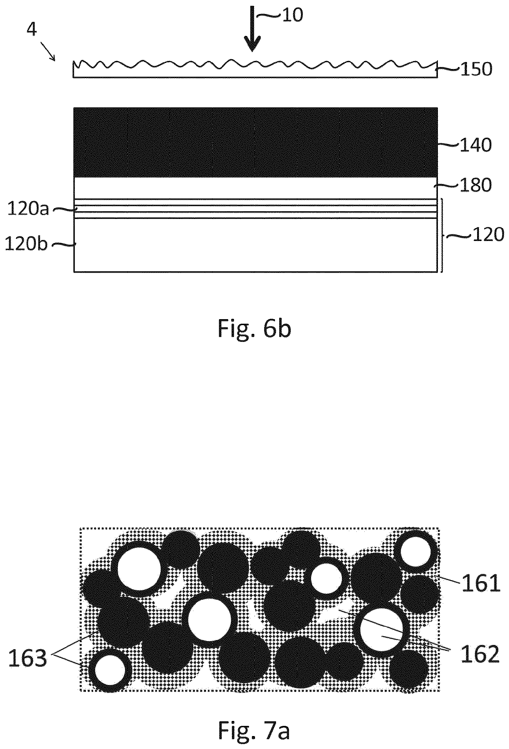

In an embodiment said front sheet 310 may comprise a light dispersion layer 160. Figs 7a-d show different variants of a light dispersion layer 160. Figs 7a shows a light dispersion layer 160 comprising a binder material 161 and at least a plurality of zones 162 having a different refractive index than said binder material. Said zones may comprise micro beads 163 that are transparent to infrared light, said micro beads 163 are substantially spherical beads 163, but may have another shape, and have a typical diameter between 0.5 µm and 100 µm. Said micro beads 163 are arranged to scatter and diffuse at least a portion of the visible light.

The refractive index difference between said micro-beads 163 and said binder material 161 is chosen so as to provide enough light dispersion. In order to obtain said refractive index difference, the micro-beads can be arranged to leave voids between said micro beads, or hollow micro beads or micro beads having a coated surface coated may also be used. The shape of said micro beads may be spherical but also irregular shaped beads may be used. Micro beads 163 have a preferred average diameter smaller than 100 µm, preferably between 1 µm and 50 µm.

Said micro beads 163 may be made of materials chosen from the group acrylic polymers, polymethylmethacrylate (PMMA), polystyrene (PS), polyethylene, glass, silica, polysylsesquioxane, silicone or alumina. Said binder material may be an acrylic based resin which polymerizes under UV radiation. Said binder material may be made porous or may contain small particles, for example high refractive index TiO2 based particles. Examples of said polymeric substrates sheets are the ones typically used as bottom diffusers in liquid crystal display (LCD) screens, such as the Optigrafix DFPM foil from Grafix plastics (Ohio).

Said light dispersion layer 160 may be realized in different ways, illustrated in Figs. 7a-d.

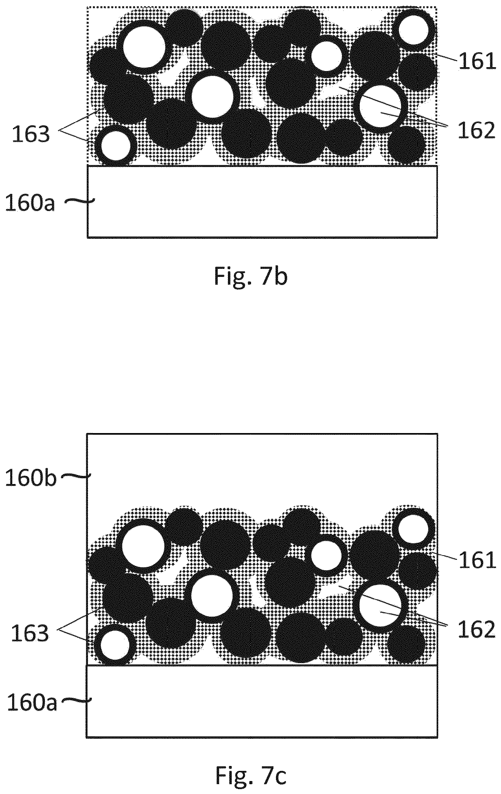

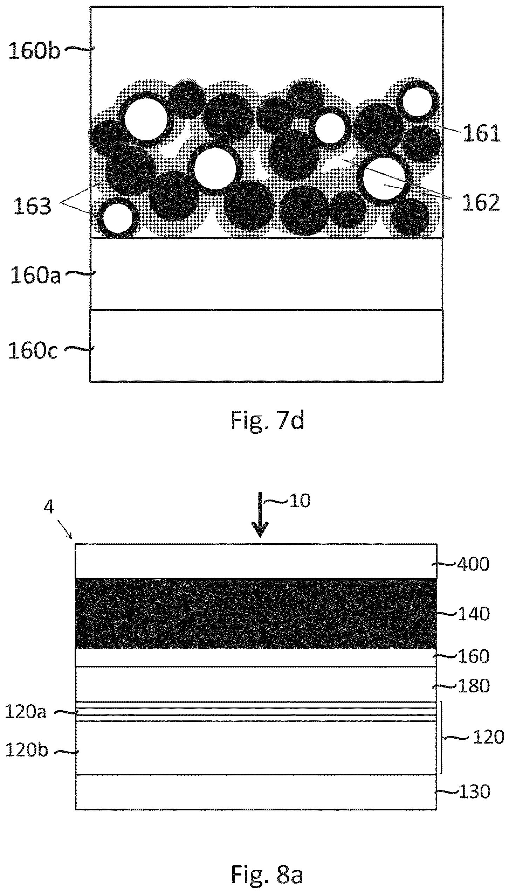

In a variant shown in Fig. 7b a polymer foil 160a is used as a carrier for a binder comprising micro beads 163. Fig 7c shows a variant in which an encapsulant layer 160b comprises said micro beads 163, said encapsulating layer 160b may serve as an adherence layer of said front sheet 310 to said second multilayer 320. In the variant of Fig 7d an additional encapsulant layer is arranged to both sides of said light dispersion layer 160. Arranging an encapsulant layer to both sides of said polymer foil allows to arrange said light dispersion layer 160 between said front sheet 310 and said second multilayer 320. Said polymer carrier foil may be fixed to said front sheet by either gluing, hot pressing or a lamination process. Said polymer carrier foil may be made from polyethylene (PET) or polycarbonate (PC). Arranging a textured surface and/or a layer of comprising microbeads to said absorption layer enlarges the design possibilities of the infrared transmitting cover sheet 4, especially in cases wherein a mate appearance of said infrared transmitting cover sheet 4, is desired.

Fig. 6a illustrates an embodiment of said third type of an infrared transmitting cover sheet 4.

Said third type of an infrared transmitting cover sheet 4 comprises at least an absorption sheet 140 and a third multilayer 120. In the embodiment of Fig. 6a said third multilayer 120 is arranged directly on said absorption sheet 140, also defined as a color filter 140. In a preferred realization of the embodiment of Fig. 6a said third multilayer 120 is deposited layer by layer on said absorption sheet.

Said color filter 140 may be a commercial color filter or may be an absorption sheet comprising absorbing substances that absorb at least a portion of said incident light, said absorption sheet 140 being transparent to infrared light. Said absorbing substances may be pigments or dyes incorporated in a material selected from the group comprising glass, Polyethylene terephthalate (PET), Polycarbonate (PC), Polyethylene napthalate (PEN), Polymethyl methacrylate (PMMA), polyesters, polyethylene (PE), polypropylene (PP), Polyethylene furanoate, polymers based on poly (bis-cyclopentadiene) condensates, fluorine based polymers, colorless polyimide (CP), cellulose, PEEK polymers, and a combination thereof.

In an embodiment said absorption sheet 140 may comprise several layers, each layer absorbing a different portion of the visible incident light. One layer may for example has higher transparency for red light and another layer may has higher transparency for blue light so that a purple appearance of the infrared transmitting cover sheet 4 is obtained.

Adding coloring substances that absorb a portion of incident visible light to an absorption sheet which is transparent for visible and near-infrared light, allows to provide third type of infrared transmitting cover sheet 4 having a wide range of predetermined color appearance choices. As there is no compatibility between all dyes and plastics, a large number of eligible plastic materials and combinations allow to provide a wide range of possibilities to create a specific color appearance of said third type of infrared transmitting cover sheet for an observer positioned at its incident light side.

Said third multilayer 120 comprises at least a third interference multilayer comprising layers made of materials chosen from the group comprising TiO2, Nb2O5, Ta2O5, ZrO2, Al2O3, SiO2, Si3N4, MgF2, a-Si, c-Si:H, Ge, SiOx, SiGe. Combining said third multilayer with said absorption front sheet 140 allows to reflect back to the incident light side the portion of visible light that is not absorbed by the absorption front sheet. The main function of said third multilayer is to guarantee the opacity of the third type infrared transmitting cover sheets for visible light, and as such assure that as less as possible visible light is transmitted by said third type of infrared transmitting cover sheet.

In an embodiment said absorption sheet 140 may be an encapsulant layer comprising added dyes or pigments. Typical materials to be used in such an embodiment are colored ethylene vinyl acetate (EVA) or polyvinyl butyral (PVB). Examples of absorption sheets 140 based on encapsulants are Evalam color foils from Hornos Industriales Pujol S.A. or colored PVB foils from the division Trosifol of the Kuraray Group in Japan.

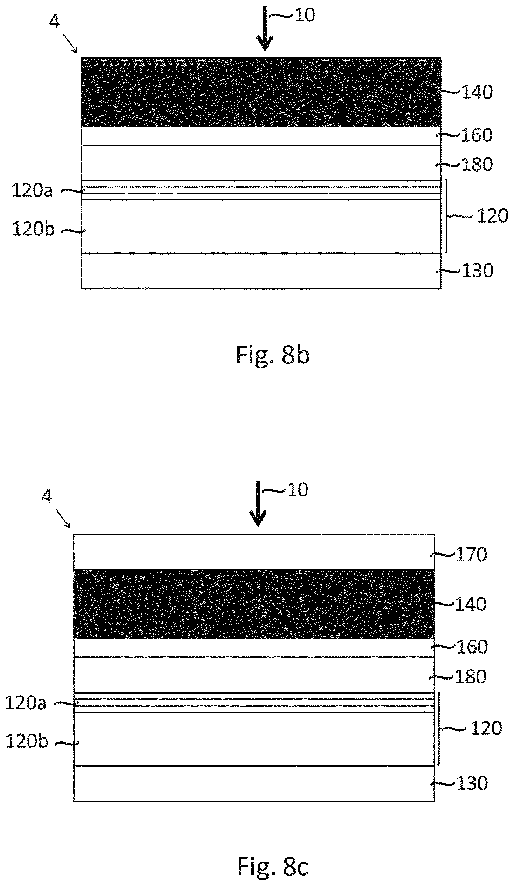

In an embodiment of said third type of infrared transmitting cover sheet 4, illustrated in Fig.8a-c, a third encapsulating layer 180 may be arranged to the incident light side of said third multilayer 120. The advantage to use said third encapsulant layer 180 is to provide a solution to arrange the third multilayer 120 to the absorption sheet 140 when said absorption sheet 140 is not based on an encapsulant material and the third interferential multilayer 120a has been arranged on a different substrate 120b than the absorption sheet 140 itself. The third encapsulant material 180 can be colored enlarging the gamma of possible colors by allowing the combination of absorption sheets 140 with colored encapsulants 180. In a variant a further fourth encapsulating layer 130 may be arranged to said third interferential layer, to the side away from said absorption sheet 140. In a variant, a third and a fourth encapsulating layers may be arranged on both sides of said third multilayer 120. The advantage of arranging a fourth encapsulating layer 130 to said third interferential layer is to provide a solution to arrange, adapt or fix said third type of infrared transmitting cover sheet to an infrared photosensitive device.

In an example of realization, said third type of infrared transmitting cover sheet 4 may be realized by the assembly or lamination of two layers, a first layer comprising said absorption sheet 140 and a second layer comprising said third multilayer 120 on which an encapsulating layer 180 has been arranged to the incident light side. Said two layers may be assembled by hot-pressing or a lamination technique. In a second variant of realization, a first layer comprises a front sheet 170 and a second layer comprises said third multilayer 120 comprising an absorption sheet which is a colored encapsulating material. In said second variant said first layer and said second layer may be assembled by hot-pressing or a lamination technique.

In an embodiment, a light dispersion layer 160, similar as the one described in paragraphs [00059] to [00063] for said second infrared transmitting cover sheet 4, may be arranged to said absorption sheet. In a variant, said light dispersion layer 160 may comprise an encapsulant layer so that said absorption sheet may be arranged to said light dispersion layer 160, by for example a lamination technique or hot-pressing technique. In an example of realization, said third type of infrared transmitting cover sheet may be realized by the assembly or lamination of three layers, a first layer comprising said absorption sheet 140, a second layer comprising said light dispersion layer 160 on which an encapsulating layer 160b has been arranged to the incident light side and a third layer comprising said third multilayer 120 on which an encapsulating layer 180 has been arranged to the incident light side. Said three layers may be assembled by hot-pressing or a lamination technique.

In an embodiment of said third type of infrared transmitting cover sheet 4 the surface of said absorption sheet to the incident light 10 may be a rough surface, defined as a surface that may scatter incident visible light, said textured surface being arranged to give a mate appearance and/or to reduce the total reflection of said third infrared transmitting cover sheet.

In an embodiment of said first, second and third type of infrared transmitting cover sheet 4 a visible light diffusing layer 150 may be arranged to the incident light side of said first, second and third type of infrared transmitting cover sheet 4, said visible light diffusing layer 150 being arranged to give a mate appearance and/or to reduce the total reflection of said infrared transmitting cover sheet 4. Said visible light diffusing layer 150 may be arranged on an additional foil, said additional foil being arranged to said infrared transmitting cover sheet 4. Exemplary light diffusing layers comprise a polymeric foil with retro-reflective features embossed on its surface. These retro-reflective features, typically being in the micrometer-millimeter range, may have a pyramidal, cubical or lenticular shape. In another example, the light diffusing layer consists of a glass sheet textured by sandblasting its surface. Arranging a visible light diffusing layer to any of the said three types of infrared transmitting cover sheets 4, enlarges the design possibilities of the infrared transmitting cover sheet 4, especially in cases wherein a mate appearance of said three types of infrared transmitting cover sheets 4 is desired.

In an embodiment of said first, second and third type of infrared transmitting cover sheets 4, an anti-reflective coating may be arranged to the incident light surface. An exemplary anti-reflective coating consists of a single layer made of MgF2. In another example, the anti-reflective coating may comprise three layers made of Al2O3, ZrO2 and MgF2.

In an embodiment of said first, second and third type of infrared transmitting cover sheet 4, a further encapsulant layer 400 may be arranged to the incident light side of said first, second and third type of infrared transmitting cover sheets 4. Said further encapsulant layer 400 allows to provide a solution to improve the adherence of said third type of infrared transmitting cover sheets 4 to a substrate such as a glass layer. Said further encapsulant layer 400 combined with the front sheet has the function to protect for example an underlying photoconversion device from the combined action of changing temperature and humidity conditions of the environment and allows to ensure a high reliability of an underlying photoconversion for at least 20 years.

In an embodiment of said first, second and third type of infrared transmitting cover sheet 4, a further encapsulant layer 400 may be arranged to the incident light side of said first, second and third type of infrared transmitting cover sheets 4 and an additional encapsulant layer may be arranged to the opposite light side of said first, second and third type of infrared transmitting cover sheet 4. Arranging an encapsulant layer to each of both sides of said first, second and third type of infrared transmitting cover sheet 4 allows to arrange and fix said first, second and third type of infrared transmitting cover sheet 4 to a first element positioned at the incident light side of said first, second and third type of infrared transmitting cover sheet 4 and to a second element positioned at the side opposite to the incident light of said first, second and third type of infrared transmitting cover sheet 4. Said first and said second element may be made of a rigid material or at least one of said first or second elements may be a flexible element, such as a polymer layer. In an embodiment of said first, second and third type of infrared transmitting cover sheet 4, the color appearance may be non-uniform and the structural features of said first, second and third type of infrared transmitting cover sheet 4 may be arranged to obtain multicolor appearances to an observer, said color appearances may represent for example logos, symbols, adds, flags.

### I) Preferred colors for each of the three types of infrared transmitting cover sheets 4.

The colored film 4 of the third type allows to obtain a huge large variety of color appearances. The colored appearance is mainly due to the absorption filter 140 arranged in said third type of color film 4, and multiple commercial products are available for such absorption filter 140: Trosifol (colored foils based on poly(vinyl butyral) (PVB), Roscolux (colored foils based on polycarbonate and polyester materials) or Lee filters. Thus, a large gamma of colors is possible for the third type of infrared transmitting cover sheets 4, therefore there is no preferred color region in the CIE diagram.

Color films 4 of the first type are suited for a narrower color range than color films of the third type. The absorption material that is principally used in color films 4 of the second type is a-Si, which is mainly absorbing at short wavelengths (i.e. smaller than 480nm). By using a-Si as the absorbing material in said first type of multilayer 230, said first type of color film is better suited to produce low luminance colors such as: grey, brown, terracotta, yellow-orange and reddish.

The second type of infrared transmitting cover sheet 4 may be chosen for similar preferred colors as in the case of a first type color film, but with the exception of dark grey and brown colors. The colors achieved using the second type of infrared transmitting cover sheet 4 have higher luminance, and have a more metallic appearance than said third type of infrared transmitting cover sheet 4 , even if the CIE coordinates are similar.

The following table summarizes the preferred colors for the three types of infrared transmitting cover sheets 4.

**Table 1. Preferred colors for each type of infrared transmitting cover sheet**

| Colored foil option | Preferred Colors | Possible Colors |
|---|---|---|
| III | All | All |
| I | Dark grey, brown, terracotta, gold and reddish | Blue, green and high luminance colors in general |
| II | Gold, copper, silver (metallic colors), white, clear grey | Blue and green |

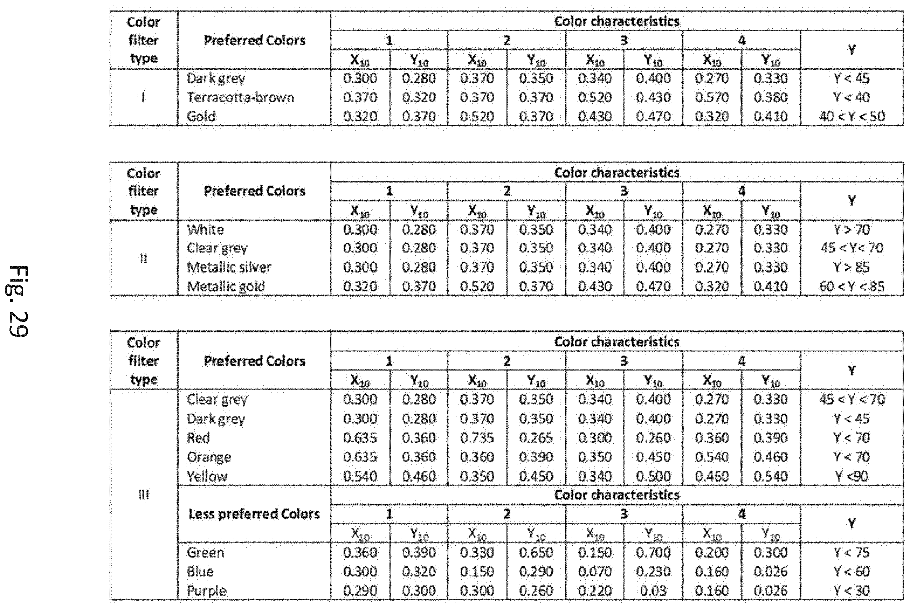

Fig. 29 shows a table defining the color coordinates of the preferred colors of Table 1 that can be obtained for the first, second and third type of infrared transmitting cover sheet 4. The area inside the CIE diagram which covers each said preferred color is defined by the x10 and y10 coordinates of the four corner points which delimit said area. In the table of Fig.29 the white and clear grey colors of the type II color filter are realized by an embodiment that comprises a diffusion layer (160) that allows to obtain a mate appearance.

It is generally understood that the infrared transmitting cover sheet may be adapted to the texture, and/or color of the photovoltaic element 2 that has to be hidden by the infrared transmitting cover sheet 4, and it also may be adapted to the color contrast between photovoltaic elements 2 and back sheet layers 20. More precisely the acceptable residual visible light that is transmitted by the infrared transmitting covers 4 is always lower than 20% of the total intensity of the incident light on the infrared transmitting cover sheet 4. In some cases this residual transmitted light intensity must be made smaller than 15%, even smaller than 10%, or even smaller than 5%, for example in the case of highly reflecting PV cells or PV cells comprising highly reflecting elements such a metal parts.

It is also generally understood that there are different ways to manage the transmitted light through the infrared transmitting covers.

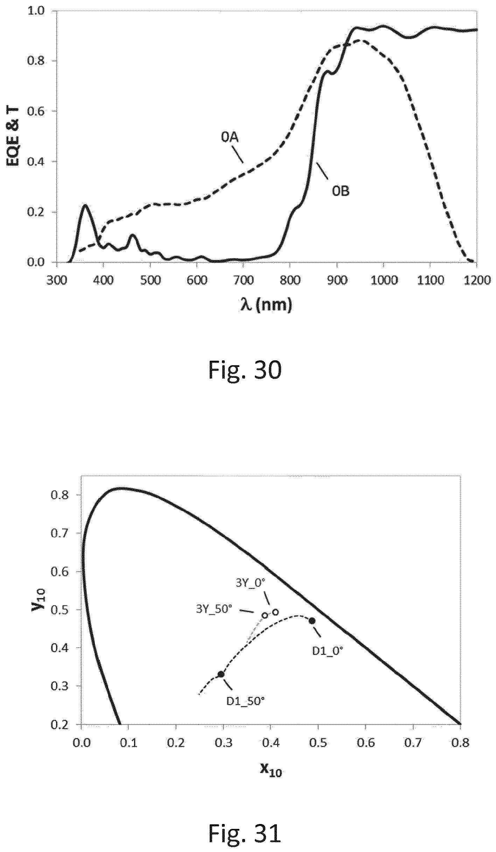

The transmitted visible light through the infrared transmitting cover sheet 4 arriving to the photovoltaic element 2 when the cover is arranged to that photovoltaic element 2 by an encapsulant layer (240, 330, 130) can be significantly higher than the visible light transmitted by the cover itself. For example, a transparent infrared cover 4 of the present invention optically coupled to a photovoltaic element 2 by an encapsulant layer (240, 330, 130), may allow to pass 30% of residual visible light, being this residual light converted into electricity by the photovoltaic element 2, while the same transparent infrared cover sheet 4 alone may transmit less than 5% of normal incident visible light. Such an example is illustrated in Fig. 30 which illustrates the transmission characteristics of an infrared transmitting cover sheet 4 (OB) and the external quantum efficiency of a solar photovoltaic module 1 (OA) built using the same infrared transmitting cover sheet 4. The external quantum efficiency (EQE) indicates the probability that a photon of a particular wavelength has to generate an electron when impinges to a solar photovoltaic module.

Different variants may be conceived with the three types of infrared transmitting cover sheets by using a light dispersion layer 160. Such a light dispersion layer scatters visible light which impinges the interference multilayer at high angles of incidence and increases its transmittance. This transmitted visible light may be absorbed and converted in to electricity by the photovoltaic elements 2.

The use of materials absorbing visible light such as silicon (Si) in the interference multilayer may be conceived with the three types of infrared transmitting cover sheets. Such materials allow to control the amount of visible light that arrives to the photovoltaic element 2 through the infrared transmitting cover 4. For example, an interference multilayer embedded between two mediums of refractive index 1.5 and containing only transparent materials will transmit around 35% of the visible light impinging at 50°, a similar stack containing silicon will reduce the visible light transmitted at the same angle to 15%. The use of such materials allows to control the amount of visible light which is transmitted through the infrared transmitting cover 4 to keep the photovoltaic element 2 attached behind invisible, even if a light dispersion layer 160 with a high scattering power is needed to give to a solar photovoltaic module 1 the desired aspect.

It is understood that absorption layers may be placed in any position inside the interference multilayer. For example, in one embodiment only one absorption layer is added to the interference multilayer to the side opposite to the incident light side.

Materials absorbing visible light such as silicon, germanium or alloys based on them have high refractive indexes which, in some cases, are close to 4. The refractive index contrast between these materials and low refractive index materials such as silicon dioxide can be as high as 2.5, which allows to fabricate thinner interference multilayers by incorporating such light absorption layers into their design. For example, an interference multilayer consisting of TiO2 and SiO2 may comprise 17 layers with a total thickness of 1.3 µm. In another example of realization an interference multilayer with half of the thickness (i.e. 0.65 µm) and an equivalent transmittance and reflectance as the interference multilayer having a thickness of 1.3 µm can be fabricated by adding hydrogenated amorphous silicon (a-Si:H) in the interference multilayer. In cases, where the desired color effect does not require a higher reflectance of visible light by the interference multilayer, interference multilayers may be designed using only light absorption materials as high refractive index materials. Such interference multilayers may consist of no more than 5 layers with total thicknesses below 0.3 µm. Thinner interference multilayers are preferable as their fabrication cost increases with their thickness.

It is also understood that in all embodiments light diffusing layers 160 and light absorption layers may be combined to obtain the desired reflection colors and/or the desired transmission of visible light.

An important characteristic of all the types of the infrared transmitting cover sheet 4 is that the perceived reflected color is substantially independent of the angle of the incident light on the infrared transmitting cover sheet 4 and of the angle with which an observer looks to the infrared transmitting cover sheet 4. The infrared transmitting cover sheet 4 has a color variance that is very low when the incidence-viewing angles are less than 70°, said angles being defined relative to the normal to the plane of the infrared transmitting cover sheet. The color variance is defined as the change in the x-coordinate and/or the γ-coordinate of the 1964 CIE color diagram when varying said incidence-viewing angles, relative to the color perceived when light is incident parallel to the normal to the plane of the infrared transmitting cover sheet and perceived by an observer looking along that normal. The color variance is less than 30%, more preferably less than 20%, even more preferably less than 10% for any incidence-viewing angle within 70° relative to said normal.

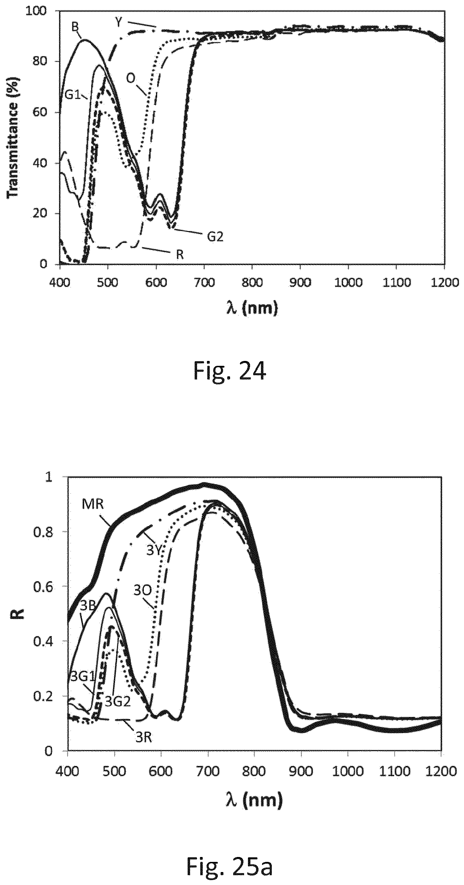

As an example Fig.31 shows the color variance of an infrared transmitting sheet of the type III. Under normal incident light and by observing the infrared transmitting sheet parallel to that normal the perceived color is yellow, defined by an x,y value of 0.4105, 0.4927 in the CIE 1964 color diagram. By changing the viewing and incident angles to 50° relative to the normal, the x and y coordinates are varied by a maximum value of -5%. Fig. 24 also shows the color variance of an infrared transmitting cover as the one disclosed in EP 1837920. Under normal incident light and by observing the infrared transmitting cover parallel to that normal the perceived color is also yellow, defined by an x,y value of 0.4876, 0.4699 in the CIE 1964 color diagram. By changing the viewing angle and incident angles to 50° relative to normal, the x and y coordinates significantly change with a variation in x,y values respect to the previous ones of - 39% and -29%, respectively.

In an embodiment at least a diffractive layer is arranged to at least one of the layers of said first multilayer or said second multilayer or said third multilayer. Said diffraction layer may be arranged to reduce the sensitivity of the color appearance relative to the incident angle of the incident light and/or the observation angle of an observer positioned to the incident light side of said solar photovoltaic module. A diffraction layer may be any diffractive structure for example a diffraction grating, a subwavelength grating or a zero order filter, or a combination of them , realized on one of the surfaces of at least one of the first, second or third multilayer.

Fig. 9 shows an example of a solar photovoltaic module of prior art comprising:
- A photovoltaic element 2;
- A back sheet layer 20;
- A back encapsulating layer 22;
- A front encapsulating layer 24;
- A protection layer 40, which is typically a glass plate.

The solar photovoltaic module 1 of the invention comprises a photovoltaic element 2 which is sensitive to near-infrared light. Preferred photovoltaic elements of the solar photovoltaic module 1 are silicon wafer-based solar cells as silicon heterojunction cells (HIT), high efficiency interdigitated back-contacted cells (IBC), standard crystalline silicon solar cells (c-Si) or multi-crystalline silicon (mc-Si) based solar cells. The use of solar cells based on germanium (Ge), Copper indium/gallium diselenide (CIGS), Copper indium selenide (CIS), Gallium arsenide (GaAs) and Indium Gallium Arsenide (InGaAs) is also a possibility due to their good response in the near infrared. Less preferable is the combination of the filter with solar cells based on amorphous silicon (a-Si), cadmium telluride (CdTe), light absorbing dyes and organic semiconductors based solar cells due to its lower response in the near infrared. Also, in the solar photovoltaic module 1 of the invention, as less as possible visible light reaches said photovoltaic element 2. Preferably, between 380nm and 600nm, more preferably between 380nm and 650 nm and more preferably between 380nm and 700nm, preferably less than 30% of light reaches said photovoltaic element 2, more preferably less than 20%, even more preferably less than 10%. The residual transmission of visible light may depend on the wavelength. It may be for example that less than 2% of incident visible light between 350 and 600nm reaches said photovoltaic element 2 and that less than 10% of incident visible light between 600nm and 700nm reaches said photovoltaic element 2. As another example, more than 2 wavelength ranges may have different low transmission values, said transmission values being always lower than 35%. The solar photovoltaic module 1 of the invention is arranged to convert substantially only near-infrared light in electricity.

In a preferred embodiment of the invention, and differing from a solar photovoltaic module of prior art, shown in Fig.10a, one of said first, second and third type of infrared transmitting cover sheets 4 is arranged on said photovoltaic element 2, to said incident light side. The incident light side is defined as the side of the solar photovoltaic module 1 to which a light source, providing the incident light 10, is positioned.

Fig. 10b shows an embodiment of the invention wherein one of said first, second and third type of infrared transmitting cover sheets 4 is arranged between said photovoltaic element 2 and said protection layer 40, which is typically a glass plate. Said first, second and third type of infrared transmitting cover sheets 4 may be any of the embodiments of said infrared transmitting cover sheets 4 containing an encapsulant layer 400 and one of the encapsulant layers 240, 330, 130 In this embodiment the colored foil 4 replace standard front encapsulant layer 24 during the assembly process of the photovoltaic module by a hot press or a lamination technique. Said infrared transmitting cover sheet 4 and said protection layer 40 are arranged to the incident light side of said photovoltaic element 2. For all embodiments of the invention comprising a protection layer 40, said protection layer 40 may be a glass layer or a polymer layer.

Fig.10c illustrates an embodiment wherein a protection layer 40 is arranged to said front encapsulating layer 24 and wherein one of said first, second and third type of infrared transmitting cover sheets 4 is arranged to the incident light side of said protection layer 40.

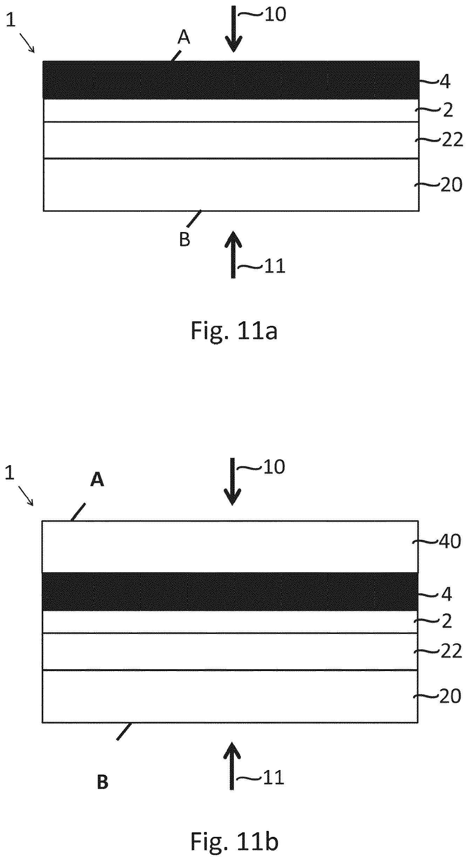

Fig.11a shows an embodiment wherein one of said first, second and third type of infrared transmitting cover sheets 4 is arranged on a bifacial photovoltaic element 2, defined as a photovoltaic cell 2 having two photosensitive sides. A first photosensitive side is arranged to the side of a light source, such as the sun, said light source providing a direct light beam of which at least a portion is incident on said solar photovoltaic module 1. A second photosensitive surface is arranged to the opposite side of said first photosensitive side.

In an embodiment illustrated in Fig.11b a first, or second, or third type of infrared transmitting cover sheets 4 is arranged to the incident light side of said photovoltaic element 2 and a protection layer 40 is arranged to the incident light side of said first, second and third type of infrared transmitting cover sheets 4. Said bifacial photovoltaic element 2 may be two photovoltaic elements arranged back-to-back so that their non-sensitive sides face each other. In all embodiments of the invention comprising bifacial photovoltaic elements, said bifacial photovoltaic elements 2 may be two photovoltaic elements arranged back-to-back so that their non-sensitive sides face each other. Also, all embodiments of the solar photovoltaic module according to the invention, comprising bifacial photovoltaic elements may be oriented with either face A, B to the main incident light beam. For example, the solar photovoltaic module 1 of the embodiment of Fig. 11a may have its first side A oriented towards the incident light beam 10, defined also as a direct incoming light beam 10, or it may have its first side A facing a reflected or scattered light beam 11 provided by the reflection or scattering of a portion of said incident light beam 10 on a reflecting surface. As an example, said reflecting surface may be a metallic surface, it may be a surface covered with snow or it may be a glass-type surface or a liquid surface.

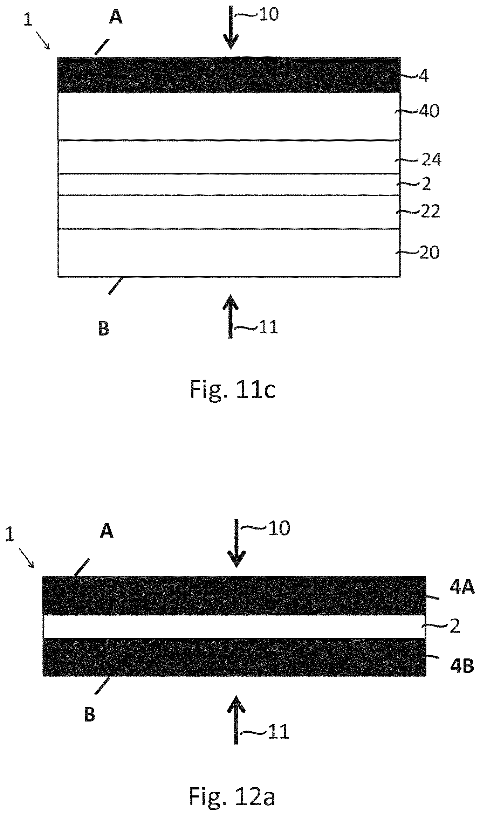

In another embodiment shown in Fig. 11c, one of the types of infrared transmitting cover sheet 4 is arranged on said protection layer 40. This embodiment, as the one shown in Fig. 10c, gives the possibility to arrange the infrared transmitting cover sheet 4 on prior art standard photovoltaic modules in a later step after their assembly. This allows that standard modules may be rendered a colored appearance once they have been realised. The exemplary embodiments of Fig.11c and Fig. 10c allows to replace infrared transmitting cover sheets 4 of photovoltaic modules 1 and to change their colored appearance during their life time with a minor investment. This process can be seen equivalent to repaint an already existing PV façade by replacing front colored foils 4.

Using a bifacial photovoltaic element 2 allows to collect reflected light 11 provided by the reflection of a portion of the light beam 10 for a surface, for example a white surface, which may be surface covered with snow. Said surface may be for example a floor or a wall or any partially reflecting or light scattering surface.

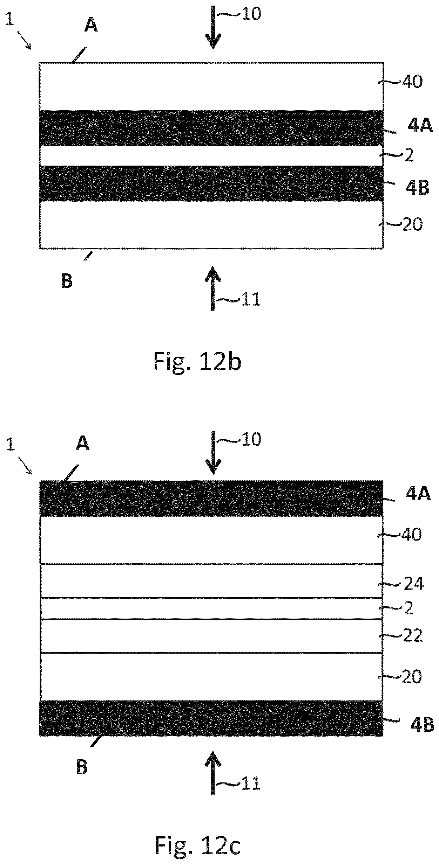

In another embodiment, illustrated in Fig. 12a, an infrared transmitting cover sheet 4 may be arranged to each side of said bifacial photovoltaic element 2. The infrared transmitting cover sheet arranged to each side of said bifacial photovoltaic element 2 may be different types of infrared transmitting cover sheet 4A, 4B. In a variant, shown in Fig. 12b, a protection layer 40 is arranged to the side of the light source, and a back sheet layer 20 is arranged to the other side. In a variant the solar photovoltaic modules may be turned 180° so that said back sheet layer 20 faces the direct incoming light beam 10 provided by a light source.

In an embodiment shown in Fig.12c, the solar photovoltaic module 1 comprises a photovoltaic element 2 to which a front 24 and back 22 encapsulating layer is arranged. To said front 24 and back 22 encapsulating layer a protection layer 40 and a back sheet layer 20 are respectively arranged. To said protection layer 40 and to said back sheet layer 20 a first, second or third type infrared transmitting cover sheet 4 is arranged. The embodiment of Fig.12c may be turned 180°, as all embodiments comprising a bifacial photovoltaic element 2.

### II) Examples of realization of solar photovoltaic modules 1 comprising first, second and third type infrared transmitting cover sheets 4.

### IIA) Examples of the realization of a solar photovoltaic module 1 comprising a first type infrared transmitting cover sheet 4:

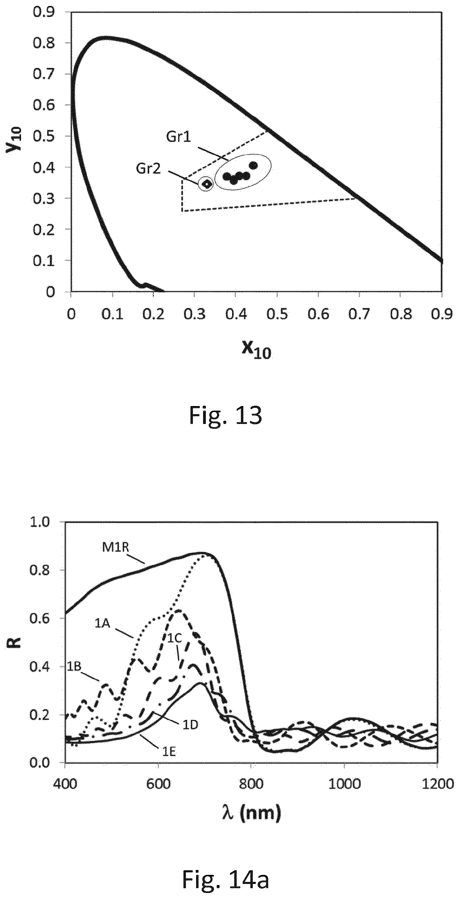

In an exemplary realization of infrared transmitting cover sheet 4 of said first type, different samples having a grey, gold, brown or terracotta-like appearance have been fabricated, said samples being, represented as Gr1 and Gr2 in the CIE 1964 color graph of Fig.13, showing the CIE 1964 color coordinates calculated using the standard D65 illuminant for the samples deposited on ZnO (Gr1) and the samples deposited on a rough acrylic material (Gr2). The dashed line in Fig.13 shows the preferred range of colors which can be obtained with an infrared transmitting cover sheet 4 of said first type.

In order to obtain type I samples, two different types of scattering layers have been used: the first colored infrared transmitting cover sheet (Gr1) is based on a ZnO layer (the refractive index of ZnO is substantially equal to 2) and the second (Gr2) one based on acrylic material (refractive index substantially equal to 1.5) The same first interferential filter made of alternative layers of amorphous silicon (a-Si) and silicon dioxide (SiO2) was deposited on top of the two types (ZnO, acrylic material) scattering layers.

Fig. 14a shows the reflection curve of an exemplary interferential filter (M1R) of the infrared transmitting cover sheet of said first type, which is deposited on 0.5 mm thick borofloat glass, and having the following structure: a-Si (15 nm)/ SiO2 (115 nm)/ a-Si (30 nm)/ SiO2 (115 nm)/ a-Si (30 nm)/ SiO2 (115 nm)/ a-Si (15 nm).

Fig. 14a shows also the reflection curves of different color filters (1A, 1B,1C,1D,1E) of the first type comprising said interferential filter deposited, for each of said color filter on different ZnO layers:
- an interferential filter comprising a first, smooth, texture (color film curve 1A) and an interferential filter comprising a second, rough, texture (color film curve 1E). Color filters of type 1A and 1E comprise a 0.5 µm and 1.5 µm thick ZnO layer deposited by LPCVD, respectively. The color filter 1A is deposited on the smoothest ZnO texture while the filter 1E is deposited on the roughest ZnO texture. The interferential filters (230) were also deposited either on a 1 µm thick ZnO (color film curve 1B) or on 1.5 µm thick ZnO layer and the original ZnO layer roughness has been smoothened under an oxygen-argon plasma treatment (color film curve 1C and 1D).

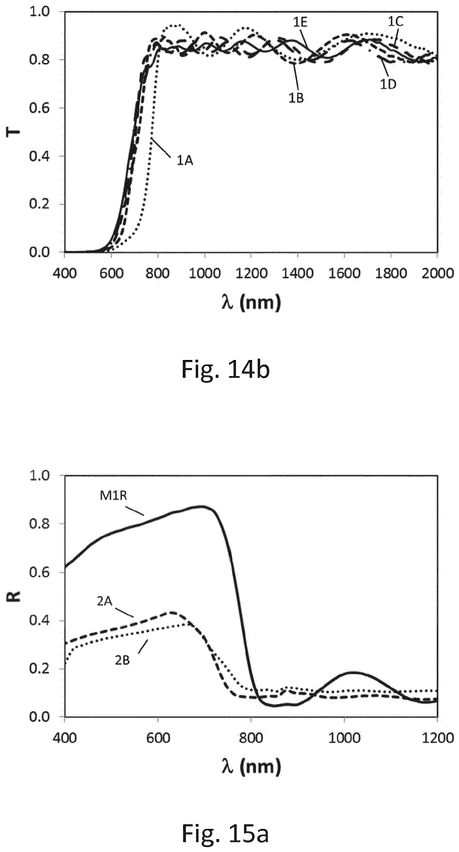

Fig. 14b shows the infrared transmission of said color filters 1A,1B,1C,1D,1E. All curves show an infrared transmission higher than 65% for wavelengths between 700nm and 2000nm, and a substantially zero transmission of visible light under 600nm and a transmission lower than 25% between 600nm and 650 nm. By adapting the layers of the color filter the transmission between 600nm and 700nm may be lower than 20%.

Fig. 15a. shows the measured reflectance of an exemplary interferential filter (M1R), identical to the one of Fig.14a, deposited on 0.5 mm thick borofloat glass. Fig. 15a also shows the reflectance curves of the same interferential filter (M1R) deposited on two different scattering layers (color filters 2A and 2B) made of an acrylic UV curable resin with a refractive index close to 1.5.

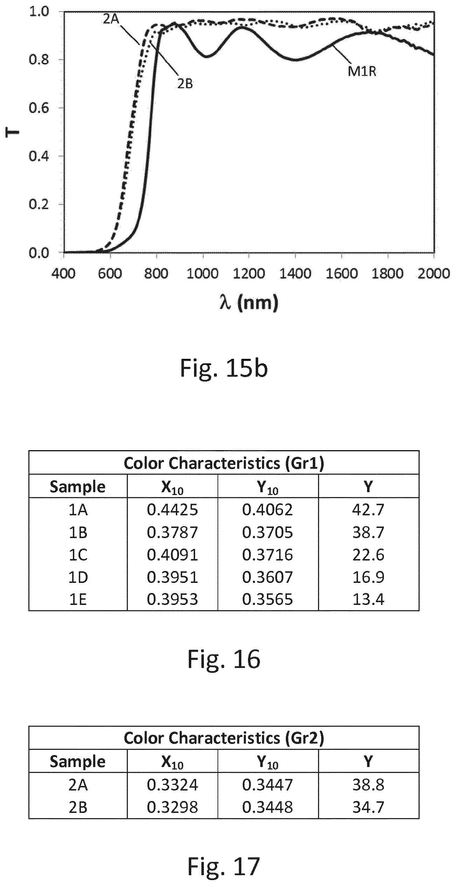

Fig. 15b shows the infrared transmission of said color filters 2A, 2B, and the interference filter M1R. All curves show an infrared transmission higher than 65% for wavelengths between 700nm and 2000nm, and a substantially zero transmission of visible light under 600nm. It may be possible to adapt the layers of the color film so that the transmission between 600nm and 700nm is smaller than 20%.

Fig. 16 and Fig. 17 summarize the color characteristics of the different examples of realizations of color films of the first type (color filters1A-1E and 2A-2B).

The table in Fig. 16 summarizes the CIE 1964 color coordinates (x10, y10) and luminance value (Y) calculated using the standard D65 illuminant for different type 1 color film samples using a scattering layer of ZnO (Gr1).

The table in Fig. 17 summarizes the CIE 1964 color coordinates (x10, y10) and luminance value (Y) calculated using the standard D65 illuminant for 2 different type 1 color films comprising a scattering layer 220 deposited on a rough acrylic material (Gr2).

Figs. 13-17 illustrate that the use of a ZnO scattering layer is a preferred choice to achieve low luminosity colors such as gold, brown and terracotta. The use of acrylic materials for the scattering layer allows to achieve more neutral color appearances having a low luminosity, such as dark grey colors. These type of colors occur frequently in building roofs and façades which makes the use of infrared transmitting cover sheet of said first type very interesting for example to adapt to PV cells and to integrate PV systems in buildings and give them an esthetic appearance.

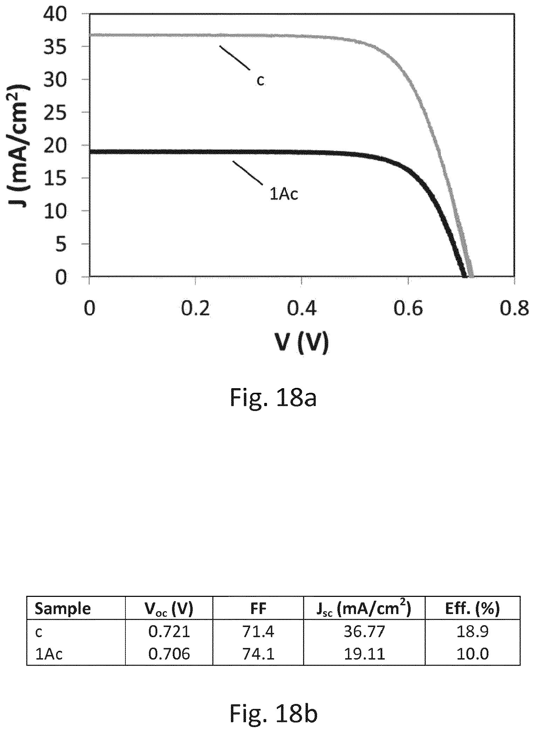

Fig. 18a shows the current density-voltage curve measured under one-sun illumination of a solar photovoltaic module 1 with and without first type infrared transmitting cover sheet. The results shown in Fig. 18a demonstrate that the current-density is still higher than 18 mA/cm² when a first type infrared transmitting cover sheet 4 is arranged to the solar photovoltaic module 1.

Fig. 18b shows a table with the main solar cell parameters measured for of a solar photovoltaic module with and without first type infrared transmitting cover sheet. The results shown in Fig.18b show that the photo-electric conversion efficiency of a solar photovoltaic modules having a first type infrared transmitting cover sheet is as high as 10%. In the table of Fig.18, Voc (V) is the open circuit voltage, FF is the fill factor, J_{sc} is the short circuit current density.

### IIB) Example of the realization of a solar photovoltaic module 1 comprising a second type infrared transmitting cover sheet 4:

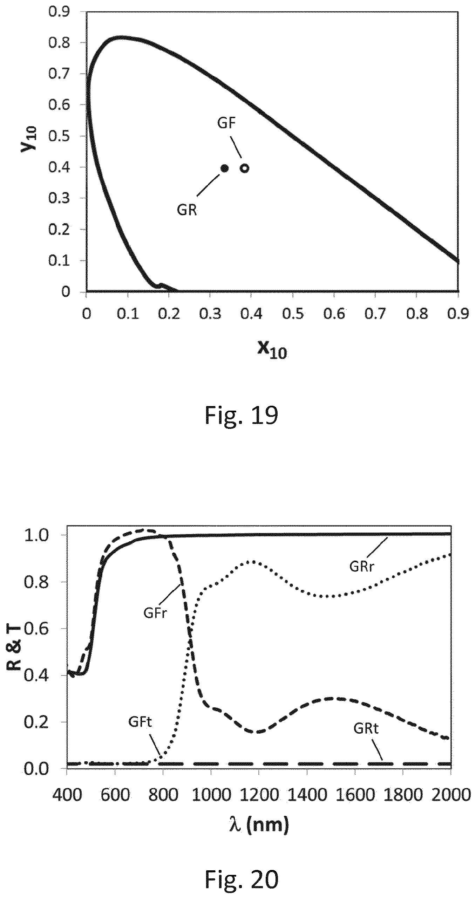

Fig. 4 shows the structural features of an exemplary second type infrared transmitting cover sheet having a visible reflection spectrum so that said infrared transmitting cover sheet has a golden colored appearance to an observer looking from the incident light side. Said golden colored appearance is represented in Fig. 19 showing the CIE 1964 color coordinates calculated using the standard D65 illuminant for the golden colored film of the second type (GF) and a reference sample made of gold (GR).

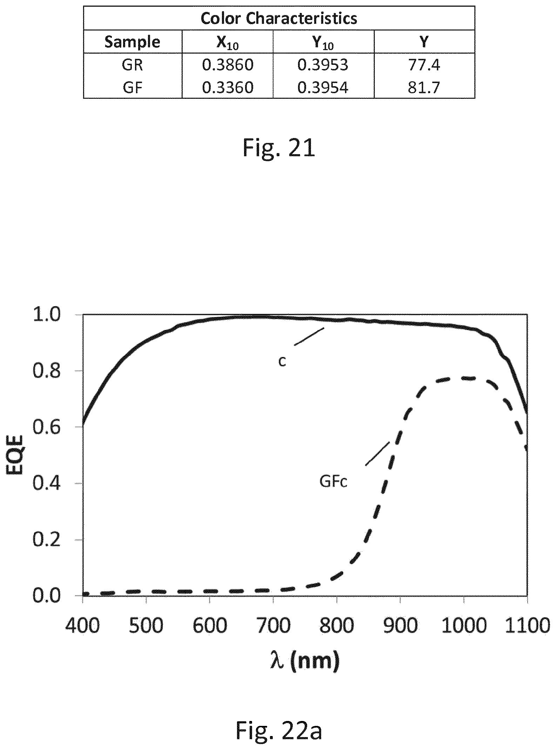

The table of Fig.21 summarizes the CIE 1964 color coordinates (x10, y10) and luminance value (Y) calculated using the standard D65 illuminant for the second type infrared transmitting cover sheet having a golden color appearance (GF) and also for a reference sample made of gold (GR).

The interferential filter 330 of said second type infrared transmitting cover sheet, having a gold appearance, is realized by depositing alternative layers of amorphous silicon (a-Si) and silicon dioxide (SiO2) grown on 1.1 mm thick borofloat glass. The layer structure of the exemplary second type infrared transmitting cover sheet is the following one: glass substrate a-Si (30 nm)/ SiO2 (120 nm)/ a-Si (40 nm)/ SiO2 (120 nm)/ a-Si (40 nm)/ SiO2 (120 nm)/ a-Si (20 nm). The second type color filter has a total of seven layers and its total thickness is: 0.495 µm.

Fig. 20 shows measured reflectances for the exemplary second type infrared transmitting cover sheet type having a golden appearance (GFr) and for a reference sample made of gold (GRr). Fig.15 also shows the measured transmittances for a second type gold color filter (GFt) and the reference sample made of gold (GRt).

Fig. 22a shows the external quantum efficiency curve of a solar photovoltaic module, with (GFc) and without (c) a second type infrared transmitting cover sheet. Fig. 22a shows that the external quantum efficiency of a solar photovoltaic module having a second type infrared transmitting cover sheet is higher than 0.7 between 930nm and 1060nm.

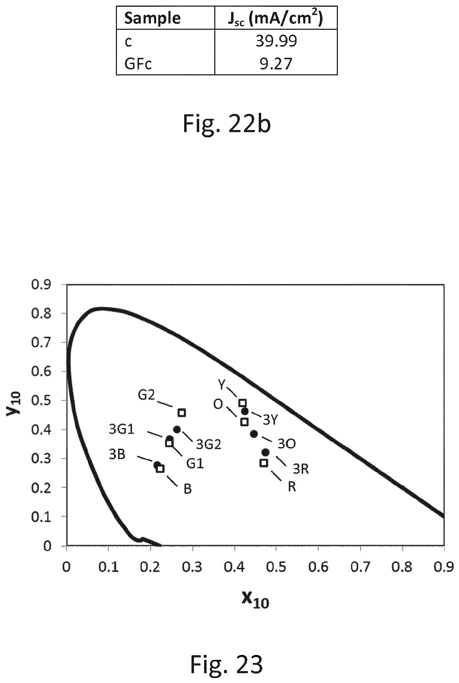

Fig. 22b shows a table with short-circuit current density values obtained by integrating the external quantum efficiency curves weighted with the AM1.5 solar spectrum over the range comprising 380nm and 1100nm for the same solar photovoltaic module as of Fig. 22a, with and without second type infrared transmitting cover sheet. The results shown in Fig.22b show that the value of J_{sc} of a solar photovoltaic module comprising a second type infrared transmitting cover sheet is still higher than 9 mA/cm².

### IIC) Examples of the realization of a solar photovoltaic module 1 comprising a third type infrared transmitting cover sheet 4:

The embodiment of Fig. 8c, without comprising layers 160 and 130, represents the structural features of an exemplary third type infrared transmitting cover sheet having a visible reflection spectrum so that said infrared transmitting cover sheet may have a wide range of colored appearance to an observer looking from the incident light side. Said wide range of colored appearance is represented in Fig.23 showing the CIE 1964 color coordinates calculated using the standard D65 illuminant for different third type infrared transmitting cover sheets and colored PVB absorption sheets (3R). The empty squares and the full circular dots in the graph of Fig. 23 represent the PVB absorption filters and the different color films of type 3, respectively.

For the infrared transmitting cover sheets of the third type, comprising an absorption sheet, also defined as color filter or color film, one may use for example commercially available colored poly(vinyl butyral) (PVB) foils from Trosifol. An exemplary interferential filter arranged on said color film 140 is made of alternative layers of amorphous silicon (a-Si) and silicon dioxide (SiO2) grown on 1.1 mm thick borofloat glass. The layer structure of the interferential filter is the following one: a-Si (15 nm)/ SiO2 (115 nm)/ a-Si (30 nm)/ SiO2 (115 nm)/ a-Si (30 nm)/ SiO2 (115 nm)/ a-Si (15 nm). The filter has a total of seven layers and its total thickness is 0.435 µm. The different type infrared transmitting cover sheets of the third type have been fabricated by laminating the interferential filter to different PVB absorption filters and to a 125 µm front sheet made of polyethylene naphtalate (PEN).

Fig. 24 shows the measured transmittances of different commercially available colored poly(vinyl butyral) (PVB) foils from Trosifol used to fabricated color films of the third type. The symbols B,G1,G2,Y,O, R stand for Blue, Dark Green, Green, Yellow, Orange and Red color films 140.

Fig.25a shows the measured reflectance of different third type infrared transmitting absorption sheets 140 realized by laminating PVB colored foils, used as absorption front sheets, to the third interferential multilayer.

The symbols 3B, 3G1, 3G2, 3Y, 3O, 3R stand for Blue, Dark Green, Green, Yellow, Orange and Red third type infrared transmitting cover sheets 4. The total reflectance (MR) of the third type interferential filter alone is also shown in Fig. 25a.

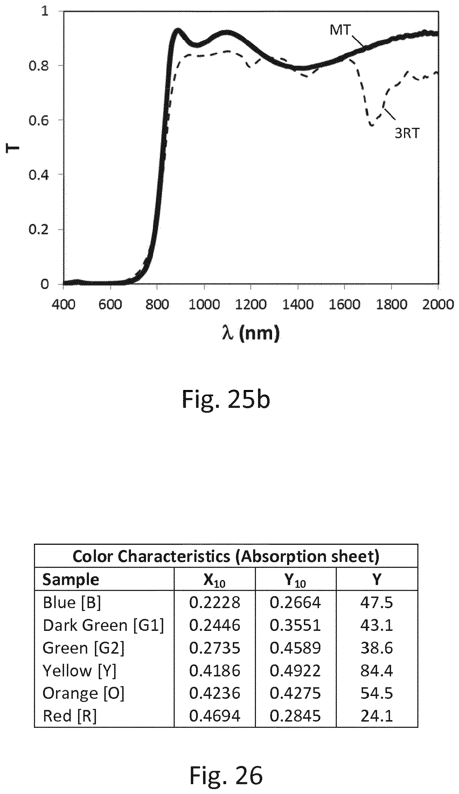

Fig. 25b shows the measured transmittance of the third type interferential filter alone (MT) and of a red (3RT) third type infrared transmitting cover sheet 4. The transmittance curves for the rest 3B, 3G1, 3G2, 3Y and 3O third type infrared transmitting cover sheets do not differ significantly from the red one (3RT) and for the sake of clarity they have not been represented in the Fig.25b.

Fig. 23 shows CIE 1964 color coordinates calculated using the standard D65 illuminant for PVB absorption filters and different infrared transmitting cover sheets of the third type fabricated using them.

Fig. 26 shows a table that summarizes the CIE 1964 color coordinates (x10, y10) and luminance value (Y) calculated using the standard D65 illuminant for the PVB absorption filters 140 used.

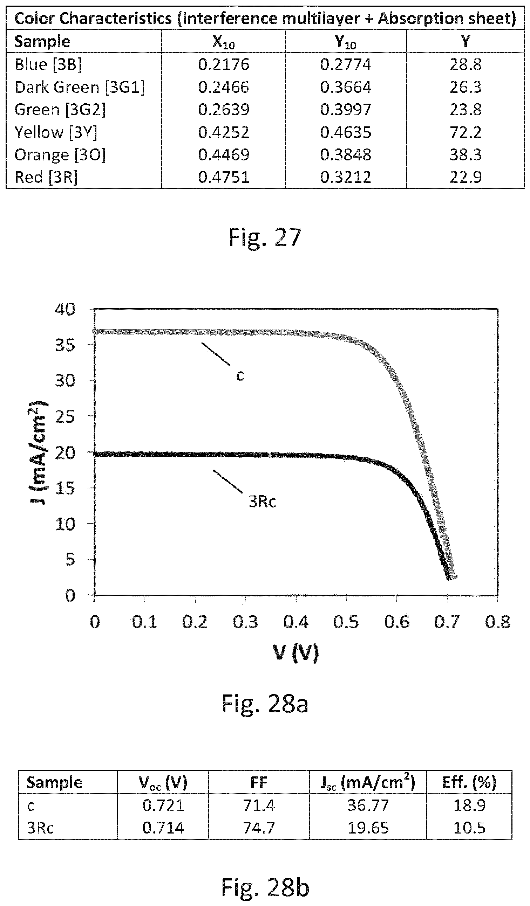

Fig. 27 shows a table that summarizes the CIE 1964 color coordinates (x10, y10) and luminance value (Y) calculated using the standard D65 illuminant for the fabricated infrared transmitting cover sheets 4 of the third type.

Fig. 28a shows a current density-voltage curve measured under one-sun illumination of a solar photovoltaic module with and without a third type infrared transmitting cover sheet 4. The results shown in Fig. 18a demonstrate that the current-density is still higher than 19.5 mA/cm² when a third type infrared transmitting cover sheet 4 is arranged to the solar photovoltaic module 1.

Fig. 28b shows a table with the main solar cell parameters measured of a solar photovoltaic module with and without a third type infrared transmitting cover sheet 4. The results shown in Fig.28b show that the photo-electric conversion efficiency of a solar photovoltaic modules having a third type infrared transmitting cover sheet is higher than 10%. In the table of Fig.28b, Voc (V) is the open circuit voltage, FF is the fill factor, J_{sc} is the short circuit current density.

In conclusion, according to the invention, it has been demonstrated that a solar photovoltaic module comprising an infrared transmitting cover sheet 4 may be realized, said infrared transmitting cover sheet 4 allowing to transmit near-infrared light, having as less as possible transmittance of visible light, said less as possible being at least lower than 25% for wavelengths lower than 650nm, and at the same time reflect a portion of the incident visible light, so that an observer positioned at the side of the incident light may not look through said infrared transmitting cover sheet 4, and perceive a predetermined color the solar photovoltaic module. It has also been demonstrated experimentally, that said infrared transmitting cover sheet 4 may be realized according to three types, each of said type being adapted to a specific color range. It has been demonstrated also that a reflection of at least 10% may be obtained for at least a preselected portion of visible incident light and that for some color appearances at least two said infrared transmitting cover sheet types may be used for the same color range. It has been demonstrated that part of the layers of said first, second and third infrared transmitting cover sheet types may be adapted to obtain special color effects, such as a metallic like appearance of said infrared transmitting cover sheet to an observer positioned to the side of the light source providing the incident light.

It has also been demonstrated that photoelectric conversion efficiencies of 10% can be reached by arranging an infrared transmitting cover sheet 4 to a solar photovoltaic module 1 which comprises a near-infrared light photosensitive element.

## Claims

1. A solar photovoltaic module (1) intended to receive incident light, said incident light comprising incident visible light and incident near infrared light, visible light being defined as light having a wavelength between 380nm and 700nm, excluding 700nm and near infrared light is defined as light having a wavelength between 700nm and 2000nm, wherein said solar photovoltaic module (1) comprises:
- a photovoltaic element (2), sensitive to near-infra red light,
- at least a first infrared transmitting cover sheet (4), arranged to one side of said photovoltaic element (2), comprising:
- infrared transmission means arranged to transmit at least 65% of said incident infrared light through said infrared transmitting cover sheet,
- visible light transmission means,
- reflection means arranged to reflect a portion of said incident visible light of said infrared transmitting cover sheet (4), to the side of said incident light,
said infrared transmission means and said visible light transmission means and said reflection means are comprised in an interference multilayer, said interference multilayer having a transmission of less than 10%, for normal incident visible light on said interference multilayer,
said infrared transmitting cover sheet (4) being arranged such that the visible light that is transmitted by the infrared transmitting cover sheet is less than 35% of the total intensity of the incident light on the infrared transmitting cover sheet (4) so that, when attached to said photovoltaic element (2), this photovoltaic element (2), becomes invisible for an observer.

2. The solar photovoltaic module (1) according to claim 1, **characterized in that** it further comprises a second infrared transmitting cover sheet (4), arranged to the other side of said photovoltaic element (2).

3. The solar photovoltaic module (1) according to claim 1 or 2, **characterized in that** said infrared transmitting cover sheet (4) comprises at least:
- a front sheet (210) arranged to the incident light side of said infrared transmitting cover sheet (4),
- a scattering layer (220) arranged on said front sheet, to the side opposite to the incident light side
- a first multilayer (230) arranged on said scattering layer (220), said first multilayer (230) comprising at least said interference multilayer, called first interference multilayer, and said first interference multilayer comprises at least one absorption layer,
said front sheet (210), said scattering layer (220) and said first multilayer (230) cooperating with one another so as to form said infrared transmission means, said visible light transmission means and said reflection means.

4. The solar photovoltaic module (1) according to claim 1 or 2, **characterized in that** said infrared transmitting cover sheet (4) comprises at least a front sheet (310) and a second multilayer (320) arranged to said front sheet (310), said second multilayer (320) comprising at least said interference multilayer, called second interference multilayer, said second interference multilayer comprising at least an absorption layer, said front sheet (310) and said second multilayer (320) cooperating with one another so as to form said infrared transmission means, said visible light transmission means and said reflection means.

5. The solar photovoltaic module (1) according to claim 4, **characterized in that** a light dispersion layer (160) is arranged on said front sheet (310), said light dispersion layer (160) comprising a binder material (161) and at least a plurality of zones (162) having a different refractive index than said binder material (161).

6. The solar photovoltaic module (1) according to claim 1 or 2, **characterized in that** said infrared transmitting cover sheet (4) comprises at least:
- an absorption sheet (140) arranged to the incident light side of said infrared transmitting cover sheet (4) and comprising substances that absorb at least a portion of said incident visible light,
- a third multilayer (120) arranged on said absorption sheet (140), to the side opposite to the incident light side, said third multilayer (120) comprising at least said interference layer, called third interference multilayer, said absorption sheet (140) and said third multilayer (120) cooperating with one another so as to form said infrared transmission means, said visible light transmission means and said reflection means.

7. The solar photovoltaic module (1) according to claim 6, **characterized in that** said absorption sheet (140) is an encapsulant layer based on a material selected from the group comprising ethylene vinyl acetate (EVA), polyvinyl butyral (PVB), polyvinyl acetate (PVA), polyurethane (TPU), thermal Polyolefin (TPO), silicone elastomers, epoxy resins, and a combination thereof, said encapsulant layer comprising substances that absorb a portion of the incident visible light.

8. The solar photovoltaic module (1) sheet according to claim 6 and 7 **characterized in that** a front sheet (170) is arranged on said absorption sheet (140) to the incident light side.

9. The solar photovoltaic module (1) according to one of claims 6 to 8, **characterized in that** said third interference multilayer is based on materials chosen from the group comprising TiO2, Nb2O5, Ta2O5, ZrO2, Al2O3, SiO2, Si3N4, MgF2, a-Si, SiOx, or combinations thereof .

10. The solar photovoltaic module (1) according to one of claims 6 to 9, **characterized in that** said third multilayer (120) comprises a third encapsulant layer (130) arranged to the side of said third multilayer (120) opposite to the incident light side.

11. The solar photovoltaic module (1) according to any one of claims 6 to 10, **characterized in that** a light dispersion layer (160) is arranged on said absorption sheet (140), said light dispersion layer (160) comprising a binder material (161) and at least a plurality of zones (162) having a different refractive index than said binder material (161).

12. The solar photovoltaic module (1) according to claim 11, **characterized in that** said zones (162) comprise micro beads (163) being transparent to infrared light, said micro beads (163) being arranged to diffuse at least a portion of the visible light, said micro beads (163) having a diameter between 0.5 µm and 100 µm.

13. The solar photovoltaic module (1) according to one of claims 1 to 12, **characterized in that** said infrared transmitting cover sheet (4) comprises an antireflection coating arranged to the incident light side of said infrared transmitting cover layer.

14. The solar photovoltaic module (1) according to one of claims 1 to 13, **characterized in that** said infrared transmitting cover sheet (4) comprises a visible light diffusing layer (150), said visible light diffusing layer (150) comprising to the side of the incident light a textured surface (151) arranged to diffuse visible light, said visible light diffusing layer (150) comprising surface microfeatures having lateral dimensions comprised between 0.1 µm and 100 µm and peak-to-valley dimensions comprised between 0.1 µm and 100 µm.

15. The solar photovoltaic module (1) according to one of claims 1 to 14, **characterized in that** said infrared transmitting cover sheet (4) comprises a further encapsulating layer (400) arranged to the incident light side of said infrared transmitting cover sheet (4).

## Patentansprüche

1. Solar-Photovoltaikmodul (1), das einfallendes Licht empfangen soll, wobei das besagte einfallende Licht einfallendes sichtbares Licht und einfallendes Nahinfrarotlicht umfasst, wobei sichtbares Licht als Licht mit einer Wellenlänge zwischen 380nm und 700nm, ausgenommen 700nm, und Nahinfrarotlicht als Licht mit einer Wellenlänge zwischen 700nm und 2000nm definiert ist,
worin das besagte solarthermische Photovoltaikmodul (1) aufweist:
- ein Photovoltaikelement (2), das gegenüber Nahinfrarotlicht empfindlich ist,
- mindestens ein erstes infrarotdurchlässiges Deckblatt (4), zu einer Seite des besagten Photovoltaikelements (2) angeordnet, umfassend:
- Infrarotübertragungsmittel, angeordnet um mindestens 65% des besagten einfallenden Infrarotlichts durch das besagte infrarotdurchlässige Deckblatt durchzulassen,
- Übertragungsmittel für sichtbares Licht,
- Reflexionsmittel, welche angeordnet sind, um einen Teil des besagten einfallenden sichtbaren Lichts des besagten infrarotdurchlässigen Deckblatts (4) auf die Seite des besagten einfallenden Lichts zu reflektieren,
wobei die besagten Infrarotübertragungsmittel und die besagten Übertragungsmittel für sichtbares Licht in einer Interferenzmehrfachschicht enthalten sind, wobei die besagte Interferenzmehrfachschicht eine Transmission von weniger als 10% für normal einfallendes sichtbares Licht auf der besagten Interferenzmehrfachschicht aufweist,
wobei das besagte infrarotdurchlässige Deckblatt (4) derart angeordnet ist, dass das sichtbare Licht, welches durch das infrarotdurchlässige Deckblatt durchgelassen wird, weniger als 35% der Gesamtintensität des einfallenden Lichtes auf das infrarotdurchlässige Deckblatt (4) ausmacht, so dass wenn am besagten Photovoltaikelement (2) angebracht, dieses Photovoltaikelement (2) für einen Beobachter unsichtbar wird.

2. Solar-Photovoltaikmodul (1) gemäss Anspruch 1, **dadurch gekennzeichnet, dass** es zudem ein zweites infrarotdurchlässiges Deckblatt (4) umfasst, welches auf der anderen Seite des besagten Photovoltaikelements (2) angeordnet ist.

3. Solar-Photovoltaikmodul (1) gemäss Anspruch 1 oder 2, **dadurch gekennzeichnet, dass** das besagte infrarotdurchlässige Deckblatt (4) mindestens umfasst:
- ein Vorderblatt (210), das zur Seite des einfallenden Lichtes des besagten infrarotdurchlässigen Deckblatts (4) angeordnet ist,
- eine Streuschicht (220), die auf dem besagten Vorderblatt auf der zur Seite des einfallenden Licht gegenüberliegenden Seite angeordnet ist,
- eine auf der besagten Streuschicht (220) angeordnete erste Multischicht (230), wobei die besagte erste Multischicht (230) mindestens die besagte Interferenzmehrfachschicht aufweist, welche erste Interferenzmehrfachschicht genannt wird, und die besagte erste Interferenzmehrfachschicht mindestens eine Absorptionsschicht umfasst,
wobei das besagte Vorderblatt (210), die besagte Streuschicht (220) und die besagte erste Multischicht (230) miteinander zusammenwirken, um die besagten Infrarotübertragungsmittel, die besagten Übertragungsmittel für sichtbares Licht und die besagten Reflexionsmittel zu bilden.

4. Solar-Photovoltaikmodul (1) gemäss Anspruch 1 oder 2, **dadurch gekennzeichnet, dass** das besagte infrarotdurchlässige Deckblatt (4) umfasst: mindestens ein Vorderblatt (310) und eine zum besagten Vorderblatt (310) angeordnete zweite Multischicht (320), wobei die besagte zweite Multischicht (320) mindestens die besagte Interferenzmehrfachschicht aufweist, welche zweite Interferenzmehrfachschicht genannt wird, wobei die besagte zweite Interferenzmehrfachschicht mindestens eine Absorptionsschicht umfasst, wobei das besagte Vorderblatt (310) und die besagte zweite Multischicht (320) miteinander zusammenwirken, um die besagten Infrarotübertragungsmittel, die besagten Übertragungsmittel für sichtbares Licht und die besagten Reflexionsmittel zu bilden.

5. Solar-Photovoltaikmodul (1) gemäss Anspruch 4, **dadurch gekennzeichnet, dass** eine Lichtdispersionsschicht (160) auf dem besagten Vorderblatt (310) angeordnet ist, wobei die besagte Lichtdispersionsschicht (160) ein Bindermaterial (161) und mindestens eine Vielzahl von Zonen (162) mit einem anderen Brechungsindex als das besagte Bindermaterial (161) umfasst.

6. Solar-Photovoltaikmodul (1) gemäss Anspruch 1 oder 2, **dadurch gekennzeichnet, dass** das besagte infrarotdurchlässige Deckblatt (4) mindestens umfasst:
- ein Absorptionsblatt (140), das zur Seite des einfallenden Lichtes des besagten infrarotdurchlässigen Deckblattes (4) angeordnet ist, und mit Substanzen, die mindestens einen Teil des besagten einfallenden sichtbaren Lichts absorbieren,
- eine dritte Mehrfachschicht (120), welche auf dem besagten Absorptionsblatt (140) auf der zur Seite des einfallenden Lichts gegenüberliegenden Seite angeordnet ist, wobei die besagte dritte Mehrfachschicht (120) mindestens die besagte Interferenzschicht umfasst, welche dritte Interferenzschicht genannt wird, wobei die besagte Absorptionsschicht (140) und die besagte dritte Mehrfachschicht (120) miteinander zusammenwirken, um die besagten Infrarotübertragungsmittel, die besagten Übertragungsmittel für sichtbares Licht und die besagten Reflexionsmittel zu bilden.

7. Solar-Photovoltaikmodul (1) gemäss Anspruch 6, **dadurch gekennzeichnet, dass** die besagte Absorptionsschicht (140) eine Verkapselungsschicht ist, welche auf einem Material basiert, das aus der Gruppe bestehend aus Ethylenvinylacetat (EVA), Polyvinylbutyral (PVB), Polyvinylacetat (PVA), Polyurethan (TPU), thermisches Polyolefin (TPO), Silikonelastomere, Epoxidharze und eine Kombination davon ausgewählt wird, wobei die besagte Verkapselungsschicht Substanzen aufweist, die einen Teil des einfallenden sichtbaren Lichts absorbieren.

8. Solar-Photovoltaikmodul (1) gemäss Anspruch 6 und 7, **dadurch gekennzeichnet, dass** ein Vorderblatt (170) auf dem besagten Absorptionsblatt (140) zur Seite des einfallenden Lichts angeordnet ist.

9. Solar-Photovoltaikmodul (1) gemäss einem der Ansprüche 6 bis 8, **dadurch gekennzeichnet, dass** die besagte dritte Interferenzmultischicht auf Materialien basiert ist, welche aus der Gruppe umfassend TiO2, Nb2O5, Ta2O5, ZrO2, Al2O3, SiO2, Si3N4, MgF2, a-Si, SiOx, oder Kombinationen davon ausgewählt werden.

10. Solar-Photovoltaikmodul (1) gemäss einem der Ansprüche 6 bis 9, **dadurch gekennzeichnet, dass** die besagte dritte Mehrfachschicht (120) eine dritte Einkapselungsschicht (130) aufweist, welche auf der Seite der besagten dritten Mehrfachschicht (120) gegenüber der Seite des einfallenden Lichts angeordnet ist.

11. Solar-Photovoltaikmodul (1) gemäss irgendeinem der Ansprüche 6 bis 10, **dadurch gekennzeichnet, dass** eine Lichtdispersionsschicht (160) auf dem besagten Absorptionsblatt (140) angeordnet ist, wobei die besagte Lichtdispersionsschicht (160) ein Bindermaterial (161) und mindestens eine Vielzahl von Zonen (162) mit einem anderen Brechungsindex als das besagte Bindermaterial (161) umfasst.

12. Solar-Photovoltaikmodul (1) gemäss Anspruch 11, **dadurch gekennzeichnet, dass** die besagten Zonen (162) Mikroperlen (163) umfassen, die für Infrarotlicht transparent sind, wobei die besagten Mikroperlen (163) so angeordnet sind, um mindestens einen Teil des sichtbaren Lichts zu diffundieren, wobei die besagten Mikroperlen (163) einen Durchmesser zwischen 0,5µm und 100µm aufweisen.

13. Solar-Photovoltaikmodul (1) gemäss einem der Ansprüche 1 bis 12, **dadurch gekennzeichnet, dass** das besagte infrarotdurchlässigen Deckblatt (4) eine Antireflexionsbeschichtung umfasst, welche auf der Seite des einfallenden Lichts der besagten infrarotdurchlässigen Deckschicht angeordnet ist.

14. Solar-Photovoltaikmodul (1) gemäss einem der Ansprüche 1 bis 13, **dadurch gekennzeichnet, dass** das besagte infrarotdurchlässigen Deckblatt (4) eine Streuschicht für sichtbares Licht (150) umfasst, wobei die besagte Streuschicht für sichtbares Licht (150) zur Seite des einfallenden Lichts eine texturierte Oberfläche (151) aufweist, die angeordnet ist, um sichtbares Licht zu diffundieren, wobei die besagte Streuschicht für sichtbares Licht (150) Oberflächenmikrostrukturen mit lateralen Abmessungen zwischen 0,1µm und 100µm und Rauhtiefen zwischen 0,1µm und 100µm aufweist.

15. Solar-Photovoltaikmodul (1) gemäss einem der Ansprüche 1 bis 14, **dadurch gekennzeichnet, dass** das besagte infrarotdurchlässige Deckblatt (4) eine weitere Einkapselungsschicht (400) umfasst, welche auf der Seite des einfallenden Lichts des besagten infrarotdurchlässigen Deckblattes (4) angeordnet ist.

## Revendications

1. Module solaire photovoltaïque (1) destiné à recevoir de la lumière incidente, ladite lumière incidente comprenant de la lumière visible incidente et de la lumière proche infrarouge, la lumière visible étant définie comme une lumière ayant une longueur d'onde comprise entre 380nm et 700nm, sauf 700nm, et la lumière proche infrarouge étant définie comme une lumière ayant une longueur d'onde comprise entre 700nm et 2000nm, dans lequel ledit module solaire photovoltaïque (1) comprend:
- un élément photovoltaïque (2), sensible à la lumière proche de l'infrarouge,
- au moins une première feuille de couverture transparente en infrarouge (4) agencée d'un côté dudit élément photovoltaïque (2) comprenant:
- des moyens de transmission infrarouge agencés pour transmettre au moins 65% de ladite lumière infrarouge incidente à travers de ladite feuille de couverture transparente en infrarouge,
- des moyens de transmission de lumière visible
- des moyens de réflexion agencés pour réfléchir une partie de ladite lumière visible incidente de ladite feuille de couverture transparente en infrarouge (4), du côté de ladite lumière incidente,
lesdits moyens de transmission infrarouge et lesdits moyens de transmission de lumière visible et lesdits moyens de réflexion étant compris dans une multicouche interférentielle, ladite multicouche interférentielle ayant une transmission inférieure à 10%, pour une lumière visible incidente normale sur ladite multicouche d'interférence,
ladite feuille de couverture transparente en infrarouge (4) étant agencée de telle manière que la lumière visible qui est transmise par la feuille de couverture transparente en infrarouge est inférieure à 35% de l'intensité totale de la lumière incidente sur la feuille de couverture transparente en infrarouge (4) de sorte que, lorsque cette dernière est fixée audit élément photovoltaïque (2), cet élément photovoltaïque (2) devient invisible pour un observateur.

2. Module solaire photovoltaïque (1) selon la revendication 1, **caractérisé en ce qu'**il comprend en outre une deuxième feuille de couverture (4) transparente en infrarouge, agencée de l'autre côté dudit élément photovoltaïque (2).

3. Module solaire photovoltaïque (1) selon la revendication 1 ou 2, **caractérisé en ce que** ladite feuille de couverture transparente en infrarouge (4) comprend au moins:
- une feuille avant (210) disposée du côté de la lumière incidente de ladite feuille de couverture transparente en infrarouge (4),
- une couche diffusante (220) disposée sur ladite feuille frontale, du côté opposé au côté de la lumière incidente,
- une première multicouche (230) agencée sur ladite couche diffusante (220), ladite première multicouche (230) comprenant au moins ladite multicouche interférentielle, appelée première multicouche interférentielle, et ladite première multicouche interférentielle comprenant au moins une couche d'absorption,
ladite feuille avant (210), ladite couche diffusante (220) et ladite première multicouche (230) coopérant entre elles de manière à former lesdits moyens de transmission infrarouge, lesdits moyens de transmission de lumière visible et lesdits moyens de réflexion.

4. Module solaire photovoltaïque (1) selon la revendication 1 ou 2, **caractérisé en ce que** ladite feuille de couverture transparente en infrarouge (4) comprend au moins: une feuille avant (310) et une deuxième multicouche (320) agencée sur ladite feuille avant (310), ladite deuxième multicouche (320) comprenant au moins ladite multicouche interférentielle, appelée deuxième multicouche interférentielle, ladite deuxième multicouche interférentielle comprenant au moins une couche d'absorption, ladite feuille avant (310), et ladite deuxième multicouche (320) coopérant entre elles de manière à former lesdits moyens de transmission infrarouge, lesdits moyens de transmission de lumière visible et lesdits moyens de réflexion.

5. Module solaire photovoltaïque (1) selon la revendication 4, **caractérisé en ce qu'**une couche de dispersion de lumière (160) est disposée sur ladite feuille frontale (310), ladite couche de dispersion de lumière (160) comprenant un matériau liant (161) et au moins une pluralité de zones (162) ayant un indice de réfraction différent de celui dudit matériau liant (161).

6. Module solaire photovoltaïque (1) selon la revendication 1 ou 2, **caractérisé en ce que** ladite feuille de couverture transparente en infrarouge (4) comprend au moins:
- une feuille d'absorption (140) disposée du côté de la lumière incidente de ladite feuille de couverture transparente en infrarouge (4) et comprenant des substances qui absorbent au moins une partie de ladite lumière visible incidente,
- une troisième multicouche (120) disposée sur ladite feuille d'absorption (140), du côté opposé au côté de la lumière incidente, ladite troisième multicouche (120) comprenant au moins ladite couche interférentielle, appelée troisième multicouche interférentielle, ladite feuille d'absorption (140) et ladite troisième multicouche (120) coopérant entre elles de manière à former lesdits moyens de transmission infrarouge, lesdits moyens de transmission de lumière visible et lesdits moyens de réflexion.

7. Module solaire photovoltaïque (1) selon la revendication 6, **caractérisé en ce que** ladite feuille d'absorption (140) est une couche d'encapsulation à base d'un matériau choisi parmi le groupe comprenant éthylène-acétate de vinyle (EVA), butyral de polyvinyle (PVB), acétate de polyvinyle (PVA), polyuréthane (TPU), polyoléfine thermique (TPO), les élastomères de silicone, les résines époxy et leurs combinaisons, ladite couche d'encapsulation comprenant des substances qui absorbent une partie de la lumière visible incidente.

8. Module solaire photovoltaïque (1) selon la revendication 6 et 7, **caractérisé en ce qu'**une feuille frontale (170) est disposée sur ladite feuille d'absorption (140) du côté de la lumière incidente.

9. Module solaire photovoltaïque selon l'une des revendications 6 à 8, **caractérisé en ce que** ladite troisième multicouche interférentielle est à base de matériaux choisis dans le groupe comprenant TiO2, Nb2O5, Ta2O5, ZrO2, Al2O3, SiO2, Si3N4, MgF2, a-Si, SiOx ou leurs combinaisons.

10. Module solaire photovoltaïque (1) selon l'une des revendications 6 à 9, **caractérisé en ce que** ladite troisième multicouche (120) comprend une troisième couche d'encapsulation (130) disposée du côté de ladite troisième multicouche (120) opposée au côté de la lumière incidente.

11. Module solaire photovoltaïque (1) selon l'une quelconque des revendications 6 à 10, **caractérisé en ce qu'**une couche de dispersion de lumière (160) est disposée sur ladite feuille d'absorption (140), ladite couche de dispersion de lumière (160) comprenant un matériau liant (161) et au moins une pluralité de zones (162) ayant un indice de réfraction différent de celui dudit matériau liant (161).

12. Module solaire photovoltaïque (1) selon la revendication 11, **caractérisé en ce que** lesdites zones (162) comprennent des microbilles (163) transparentes à la lumière infrarouge, lesdites microbilles (163) étant agencées pour diffuser au moins une partie de la lumière visible, lesdites microbilles (163) ayant un diamètre compris entre 0,5µm et 100µm.

13. Module solaire photovoltaïque (1) selon l'une des revendications 1 à 12, **caractérisé en ce que** ladite feuille de couverture (4) transparente en infrarouge comprend un revêtement antireflet agencé du côté de la lumière incidente de ladite couche de couverture transparente en infrarouge.

14. Module solaire photovoltaïque (1) selon l'une des revendications 1 à 13, **caractérisé en ce que** ladite feuille de couverture transparente en infrarouge (4) comprend une couche de diffusion de lumière visible (150), ladite couche de diffusion de lumière visible (150) comprenant sur le côté la lumière incidente une surface texturée (151) agencée pour diffuser la lumière visible, ladite couche de diffusion de lumière visible (150) comprenant des microéléments de surface ayant des dimensions latérales comprises entre 0,1µm et 100µm et des dimensions pic-vallée comprises entre 0,1µm et 100µm.

15. Module solaire photovoltaïque (1) selon l'une des revendications 1 à 14, **caractérisé en ce que** ladite feuille de couverture transparente en infrarouge (4) comprend une autre couche d'encapsulation (400) disposée du côté de la lumière incidente de ladite feuille de couverture transparente en infrarouge (4).
